# EUROPEAN PATENT APPLICATION

(11) **EP 1 030 357 A1**
(43) Date of publication of application: **23.08.2000**
(21) Application number: 97909706.0
(22) Date of filing: 30.10.1997
(51) Int. Cl.: H01L 21/60, H01L 23/12

(54) **SEMICONDUCTOR DEVICE AND METHOD FOR MANUFACTURING THE SAME**

(71) Applicant: Hitachi, Ltd., Chiyoda-ku, Tokyo 101 (JP)
(72) Inventor: MIYAMOTO, Toshio, Kodaira-shi, Tokyo 187 (JP); ANJO, Ichiro, Koganei-shi, Tokyo 184 (JP); ARITA, Junichi, Musashimurayama-shi, Tokyo 208 (JP); EGUCHI, Shuji, Tokaimura, Naka-gun, Ibaraki 319-11 (JP); KITANO, Makoto, Tsuchiura-shi, Ibaraki 300 (JP); KUBO, Masaharu, Hachioji-shi, Tokyo 192 (JP); MUNAKATA, Takeshi, Tokyo 178 (JP); FUKUDA, Takuya, Kodaira-shi, Tokyo 187 (JP)
(74) Representative: Paget, Hugh Charles Edward
(86) International application number: JP9703969
(87) International publication number: WO9923696

(57) **Abstract**

A chip size package in which an elastomer of low elasticity for damping and absorbing a stress, as might otherwise be concentrated on bump electrodes, is formed over the principal face of a semiconductor chip and in which wires connected with bonding pads are led out to the upper face of the elastomer through through holes formed in the elastomer and are connected at their one-end portions with the bump electrodes. On the other hand, the wires, as led out to the upper face of the elastomer are formed in a curved pattern so that the stress to be concentrated on the bump electrodes may be absorbed and damped by the extension and contraction of not only the elastomer but also the wires.

## Description

### TECHNICAL FIELD

The present invention relates to a semiconductor device and a process for manufacturing it and, more particularly, to a technique which is effective when applied to a chip size package (Chip Size Package: CSP) type semiconductor device having a semiconductor chip packaged on a substrate through bump electrodes.

### BACKGROUND ART

The BGA (Ball Grid Array) type LSI package, in which a semiconductor device is packaged in a flip chip over a substrate by using ball-shaped bump electrodes mounted over electrodes (or pads), is frequently employed not only as the package for packaging the logic LSI having many I/O (Input/Output) pins but also as the package for packaging the memory LSI, because it can be equipped with many pins while reducing the packaging area.

The BGA, as disclosed in USP No. 5,216,278, for example, is provided with the package structure in which the chip is mounted by the wire bonding method over a package substrate of plastics having bump electrodes of a solider of Pb-Sn alloy on its back face and is sealed with a mold resin.

Thus, the BGA provides a structure in which there are jointed different kinds of members having different coefficients of thermal expansion such as the semiconductor chip made of single crystalline silicon, the package substrate made of plastics (or ceramics) or the bump electrodes made of the Pb-Sn alloy solder. As a result, if the semiconductor chip is repeatedly subjected to the temperature cycle of heating/cooling steps after the BGA was packaged over the printed-circuit board, the stress is concentrated at the bump electrodes due to the difference in the thermal expansion coefficients among the members. This stress concentration may shorten the bump lifetime to lower the electric connection reliability or to cause the breakage of the bump electrodes, as the case may be.

This problem will not be actualized when the bump electrodes have a relatively large diameter, because the bump electrodes themselves have a stress absorbing ability of some extent. When the diameter of the bump electrodes is so small as that of the BGA having many I/O pins or the chip size package (CSP) reduced to substantially the same size as that of the chip, however, a serious problem arises to lower the stress absorbing ability of the bump electrodes. In the design of the BGA or especially the CSP, therefore, design techniques are required for making the individual members of materials having approximate thermal expansion coefficients or for interposing such a member in the gap between the chip and the substrate as will damp and absorb the stress to be applied to the bump electrodes.

Japanese Patent Laid-Open No. 102466/1996 has disclosed a process in which the bump electrodes are formed in a grid shape in the individual chip areas of a semiconductor wafer and in which the wafer is then divided into multiple chips. In this process, first of all, wires, as connected with pads formed in the peripheral edge portion of each chip area of the wafer, are led inside of the chip area. Then, the wafer is coated all over its surface with a cover coat of polyimide or the like. This cover coat is opened into a grid pattern to expose the wires to the outside, and bump electrodes are formed thereover. After this, the wafer is diced along scribe lines and divided into multiple chips. According to this manufacture process, the work of arranging the bump electrodes in the grid shape inside of the chip is performed by a wafer process so that the chips having the bump electrodes can be mass-produced.

Japanese Patent Laid-Open No. 283843/1989 has disclosed a process in which the wafer is coated on its surface (excepting the area having the bump electrodes) with a thermoplastic resin (e.g., polymethyl methacrylate) for damping the stress to be applied to the bump electrodes and in which the wafer is then diced and divided into multiple chips. This process is advantageous in that the packaged chip can be easily repaired and that no bubble is left in the gap between the chip and the substrate, over the process in which the gap between the chip and the substrate is charged with a resin after the chip was packaged over the substrate through the bump electrodes.

Japanese Patent Laid-Open No. 280458/1992 has disclosed an LSI package in which the stress to be generated due to the difference in the thermal expansion coefficient between the chip and the substrate is absorbed and damped by means of a rubbery elastomer (e.g., silcone rubber having a modulus of elasticity of 100 MPa or less) having projections on its surface, by sealing the chip with the rubbery elastomer. Over the surface of the rubbery elastomer, there are formed wires which are connected at their ends with the pads of the chip and extended at their other ends over the surfaces of the projections. When this package is to be mounted over the substrate, the wires over the surfaces of the projections are soldered to the electrodes of the substrate.

Japanese Patent Laid-Open No. 111473/1996 has disclosed a BGA type package in which there is interposed between a chip and bump electrodes an elastomer of low elasticity (e.g., syloxane polymer having a glass transition temperature of -50 °C or less) for damping the stress to be generated due to the difference in the thermal expansion coefficient between the chip and the substrate. This elastomer is adhered to the surface of the chip by means of an adhesive, and the pads of the chip and the bump electrodes are electrically connected through conductors which are buried in the elastomer.

"Nikkei Micro Device" (pp. 92 to 98), as issued by Nikkei BP Co., Ltd. (in October, 1996), has disclosed a (wafer level packaging) process in which an elastic resin layer and a polyimide substrate layer are laminated on the surface of a wafer so that bump electrodes are connected over Cu wires formed over the polyimide substrate layer and in which the wafer is then diced to manufacture multiple chip size packages (CSP). The pads of the wafer and the wires of the polyimide substrate layer are electrically connected through leads or bonding wires which are buried in the elastic resin layer of the chip surface.

Japanese Patent Laid-Open No. 77138/1990 has disclosed a technique for damping the stress to be applied to bump electrodes of a chip, by connecting the bump electrodes and the electrodes of a substrate through thin, helical wires (as called the "micro leads") having spring properties or a free deformability in all directions including horizontal and vertical direction. The micro leads are formed by laminating a plurality of different kinds of metal films over the substrate by the sputtering method, by etching these metal films into helical patterns and by lifting off the metal film of the lowermost layer.

USP No. 5,476,211 has disclosed a technique in which a wire is bonded at its two ends on a common pad of a chip to form a looped projection to package a semiconductor chip over a substrate through the projection. In another mode of this Laid-Open, moreover, the wire is bonded at its one end over the pad and is then formed in its entirety into an S-shape or a straight shape so that its other end side is connected with the substrate.

Japanese Patent Laid-Open No. 177434/1988 has disclosed a packaging structure in which helical, conductive springs are formed altogether over an insulating sheet and having a height no larger than the minimum transverse size are sandwiched between a bump electrode formed over the pad of a chip and a substrate. The conductive springs are formed by etching a Cu alloy or the like over a thin sheet adhered to the insulating sheet of polyimide and are fixed at their ends on the insulating sheet. According to this packaging structure, the individual back faces of a plurality of chips can be aligned in their heights even if a substrate has a warpage when the chips are packaged over the substrate. As a result, all the chips can be held in close contact with a cooling plate when this cooling plate is arranged on the back faces of the chips.

Japanese Patent Laid-Open No. 129772/1997 has disclosed a chip scale package in which the step of assembling a package after a wafer was divided into chips is eliminated by using the back face and side faces of a chip as a portion of the package and by using a passivation film covering the element forming face of the chip as a portion of the package. This package is manufactured by covering the individual chip areas of the wafer with a two-layered passivation film and by arranging electrodes for connecting bump electrodes thereover in a grid shape. The individual electrodes are electrically connected with the corresponding pads through through holes, which are formed by opening the upper passivation film, and through wires which are formed over the lower passivation film. The wafer is subjected in this state to tests for its function or a burn-in test, before being divided into chips by dicing. After this, the bump electrodes are connected with the electrodes of each chip.

Japanese Patent Laid-Open No. 250498/1996 has disclosed a technique in which bump electrodes are formed at predetermined positions of wires led out from pads without being restricted by the position or spacing of the pads. The wires led out from the pads are covered on their surfaces with a layer insulating layer of photosensitive polyimide so that the bump electrodes are formed through a conductive layer over the wires which are exposed from the openings formed in the layer insulating layer. According to this structure, the bump electrodes can be formed to an arbitrary height so that the bump lifetime can be prolonged by suppressing the thermal fatigue of the bump electrodes, as might otherwise be caused due to the difference in the thermal expansion coefficients between the chip and the substrate.

We have examined in various manners both the semiconductor device of the prior art, in which the semiconductor chips are flip-chip packaged over the substrate by using the aforementioned bump electrodes, and the process for manufacturing the semiconductor device, and have found out a novel CSP structure having a structure capable of effectively damping and absorbing the stress, as might otherwise be concentrated on the bump electrodes due to the difference in the thermal expansion coefficients between the chip and the substrate, and a process for manufacturing the CSP structure at a reasonable cost.

An object of the invention is to provide both a CSP type semiconductor device having a structure capable of effectively damping and absorbing the stress, as might otherwise be concentrated on the bump electrodes, which are the junctions of the semiconductor chip and the substrate, due to the difference between the thermal expansion coefficients of the two, and a technique for manufacturing the semiconductor device at a reasonable cost.

The aforementioned and other objects and novel features of the invention will become apparent from the following description to be made with reference to the accompanying drawings.

### DISCLOSURE OF THE INVENTION

The representatives of the invention disclosed herein will be briefly summarized in the following.

According to the invention, there is provided a semiconductor device in which an elastomer of low elasticity for damping and absorbing a stress, as might otherwise be concentrated on bump electrodes, is formed over the principal face of a semiconductor chip and in which wires connected with pads are led out to over the upper face of the elastomer through through holes formed in the elastomer and are connected at their one-end portions with the bump electrodes. There is provided another semiconductor device, in which the wires, as led out to upper face of the elastomer are formed in a curved pattern so that the stress to be concentrated on the bump electrodes may be absorbed and damped by the elastic deformation of the elastomer and by the extension and contraction of the wires.

According to the invention, there is further provided a process for manufacturing a semiconductor device, in which the step of assembling a package is eliminated by performing the steps up to the connections of the bump electrodes with the wires by a wafer process, by performing a testing of the burn-in in this state and subsequently by dicing and dividing the wafer into chips.

The summary of the invention, as disclosed herein, will be itemized in the following.
1. In a semiconductor device of the invention, art elastomer layer is formed over a plurality of semiconductor elements and bonding pads, which are formed over a plurality of chip areas of the principal face of a semiconductor wafer, and bump electrodes are electrically connected at their one-end portions with said bonding pads through through holes opened in said elastomer and at their other end portions with wires arranged over said elastomer layer.
2. The semiconductor device of the invention is a chip size package type semiconductor device having semiconductor chips obtained by dividing the chip area of the semiconductor wafer.
3. In the semiconductor device of the invention, a protective layer is formed on the side faces of said semiconductor chip.
4. In the semiconductor device of the invention, said wires are formed over one face of an insulating tape jointed to the upper face of said elastomer layer, and said wires and said bonding pads are electrically connected through Au bumps jointed to the upper faces of said bonding pads.
5. In the semiconductor device of the invention, a plurality of stages of Au bumps are jointed over said bonding pads.
6. In the semiconductor device of the invention, said Au bumps are sealed with a resin filled in the through holes of said elastomer layer.
7. In the semiconductor device of the invention, said elastomer layer is made of either a photosensitive resist applied to the principal face of said semiconductor wafer or a photosensitive film adhered to the principal face of said semiconductor wafer.
8. In the semiconductor device of the invention, said elastomer layer has a modulus of elasticity of 1 to 5,000 MPa.
9. In the semiconductor device of the invention, said elastomer layer has a modulus of elasticity of 1 to 1,000 MPa.
10. In the semiconductor device of the invention, said elastomer layer has a modulus of elasticity of about 1 to 500 MPa.
11. In the semiconductor device of the invention, said elastomer layer has a film thickness of 0.005 to 0.15 mm. 12. In the semiconductor device of the invention, said elastomer layer has a film thickness of 0.01 to 0.1 mm.
13. In the semiconductor device of the invention, said elastomer layer has a film thickness of 0.02 to 0.1 mm.
14. In the semiconductor device of the invention, said bump electrodes have a spacing larger than that of said bonding pads.
15. In the semiconductor device of the invention, said elastomer layer has an undulated surface.
16. In the semiconductor device of the invention, said elastomer layer in the vicinity of said bump electrodes have slits.
17. In the semiconductor device of the invention, the wires arranged over said elastomer layer are formed at least partially to have a curved pattern.
18. In the semiconductor device of the invention, the wires arranged over said elastomer layer are formed at least partially to have a plurality of wires.
19. In the semiconductor device of the invention, the wires arranged over paid elastomer layer are oriented at a right angle with respect to the direction joining the bump electrodes connected with said wires and the center of said chip area, and the wires arranged at the peripheral edge portion of said chip area are longer than the wires arranged at the center portion of said chip area.
20. A process for manufacturing a semiconductor device of the invention, comprising:
   (a) forming an elastomer layer over a plurality of semiconductor elements and bonding pads, which are formed in a plurality of chip areas of the principal face of a semiconductor wafer;
   (b) forming through holes over said bonding pads or the electrode wires which are electrically connected with said bonding pads, by opening said elastomer layer;
   (c) forming wires to be electrically connected at their one-end portions with said bonding pads through said through holes and to be arranged at their other end portions over said elastomer layer; and
   (d) connecting bump electrodes with the other end portions of the wires arranged over said elastomer layer.
21. A process for manufacturing a semiconductor device of the invention, comprising:
   (a) forming an elastomer layer over a plurality of semiconductor elements and bonding pads, which are formed in a plurality of chip areas of the principal face of a semiconductor wafer;
   (b) forming through holes over said bonding pads or the electrode wires which are electrically connected with said bonding pads, by opening said elastomer layer;
   (c) jointing an insulating tape having wires on its one face to the upper face of said elastomer layer to connect the one-end portions of said wires and said bonding pads electrically through said through holes; and
   (d) connecting bump electrodes with the other end portions of the wires arranged over said elastomer layer.
22. The semiconductor device manufacturing process of the invention further comprising: dicing and dividing the chip areas of said semiconductor wafer into semiconductor chips.
23. The semiconductor device manufacturing process of the invention further comprising: making a test prior to dicing and dividing said chip areas into said semiconductor chips, to classify said plurality of chip areas into non-defective and defective ones.
24. The semiconductor device manufacturing process of the invention further comprising: forming a fuse using at least a portion of the wires arranged over said elastomer layer, to blow the fuse of the chip areas which are determined to be defective by said testing.
25. The semiconductor device manufacturing process of the invention further comprising: forming slits in the principal face or back face of said semiconductor wafer at the boundary of said chip areas, and forming protective layers in said slits.
26. A process for manufacturing a semiconductor device of the invention, comprising:
   (a) forming a plurality of semiconductor elements and a plurality of bonding pads over the individual principal planes of a plurality of chip areas defined by scribe lines;
   (b) forming an elastomer layer over the principal faces of said plural chip areas;
   (c) forming through holes in said elastomer layer at positions, as corresponding to said plurality of bonding pads, individually in said plurality of chip areas;
   (d) forming such conductive layers individually in said plurality of chip areas which are formed at their one-end portions over said elastomer layer and connected at their other end portions with the corresponding ones of said bonding pads through said through holes;
   (e) forming bump electrodes individually in said plurality of chip areas as which are connected with the one-end portions of said conductive layers; and
   (f) cutting said semiconductor wafer along said scribe lines to form over its principal face a plurality of semiconductor chips having said elastomer layers, said conductive layers and said bump electrodes.
27. A semiconductor device manufacturing process of the invention, wherein said elastomer layer is formed of a photosensitive film, and said through holes are formed by the photolithography technique and the etching technique.
28. A semiconductor device manufacturing process of the invention, wherein the step (d) of forming said conductive layers includes: forming Au bump electrodes over said bonding pads; and forming a wiring layer over said Au bump electrodes.
29. A semiconductor device manufacturing process of the invention, wherein the step (d) of forming said conductive layers includes; forming a metal layer all over the surface of said elastomer layer including the insides of said through holes; and forming a wiring layer by patterning said metal layer.

### BRIEF DESCRIPTION OF THE DRAWINGS

Fig. 1 is a perspective view of a semiconductor device according to one embodiment of the invention;
Fig. 2 is a section of the semiconductor device;
Fig. 3 is a section of the semiconductor device packaged over a substrate;.
Fig. 4 is a perspective view showing the upper face of an insulating tape or a member constructing the semiconductor device;
Fig. 5 is a perspective view showing the lower face of the same insulating tape;
Fig. 6 is a top plan view showing a process for manufacturing a semiconductor device according to one embodiment of the invention;
Figs. 7 to 18 are sections showing the process for manufacturing the semiconductor device according to the embodiment of the invention;
Fig. 19 is an overall flow diagram showing the process for manufacturing the semiconductor device according to the embodiment of the invention;
Figs. 20 to 23 are sections of semiconductor devices according to other embodiments of the invention;
Fig. 24 is a perspective view of a semiconductor device according to another embodiment of the invention;
Fig. 25 is a section of the semiconductor device according to said another embodiment of the invention;
Fig. 26 is a perspective view of a semiconductor device according to another embodiment of the invention;
Fig. 27 is a section of the semiconductor device according to said another embodiment of the invention;
Fig. 28 presents top plan views showing the patterns of wires or members constructing the semiconductor device;
Fig. 29 is a top plan view showing a process for manufacturing the semiconductor device according to said another embodiment of the invention;
Figs. 30 to 38 are sections showing the process for manufacturing the semiconductor device according to said another embodiment of the invention;
Figs. 39 and 40 are sections showing semiconductor devices according to other embodiments of the invention;
Fig. 41 is a top plan view showing a semiconductor device according to another embodiment of the invention;
Fig. 42 is a section showing the semiconductor device according to said another embodiment of the invention;
Fig. 43 is a section showing a semiconductor device according to another embodiment of the invention;
Figs. 44 to 48 are sections showing a process for manufacturing the semiconductor device according to said another embodiment of the invention;
Figs. 49 to 51 are sections showing semiconductor device according to other embodiments of the invention;
Fig. 52 is an enlarged top plan view showing a wiring of a semiconductor device according to another embodiment of the invention;
Figs. 53 and 54 are sections showing methods of testing the semiconductor device according to other embodiments of the invention;
Fig. 55 is a top plan view showing a semiconductor device according to another embodiment of the invention;
Fig. 56 is an enlarged top plan view showing a wiring of the semiconductor device according to another embodiment of the invention; and
Figs. 57 and 58 are sections showing wiring of semiconductor devices according to other embodiments of the invention.

### BEST MODE FOR CARRYING OUT THE INVENTION

The invention will be described in detail in connection with its embodiments with reference to the accompanying drawings. Here, throughout the drawings for explaining the embodiments, the members having identical functions will be designated by the common reference numerals, and their repeated description will be omitted.

### Embodiment 1

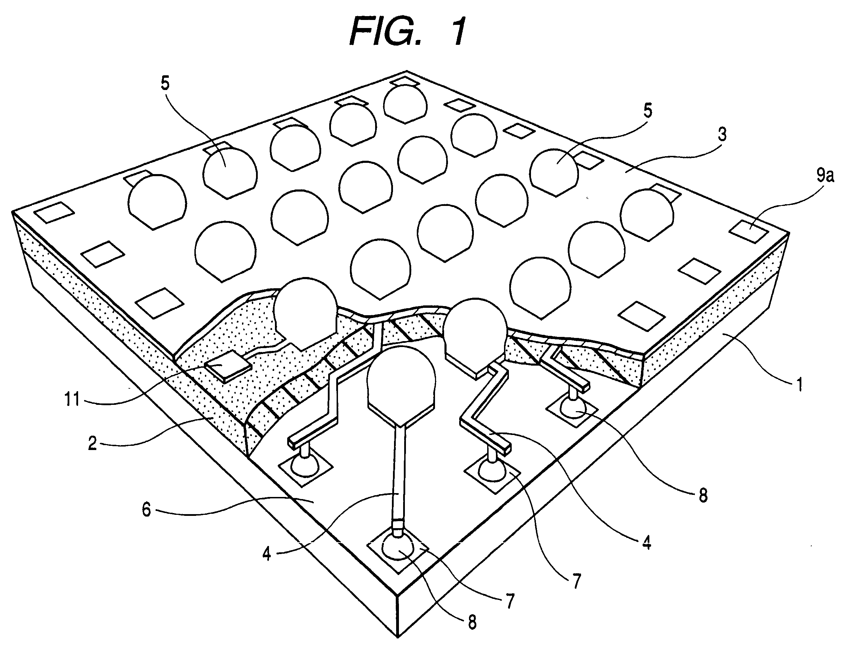

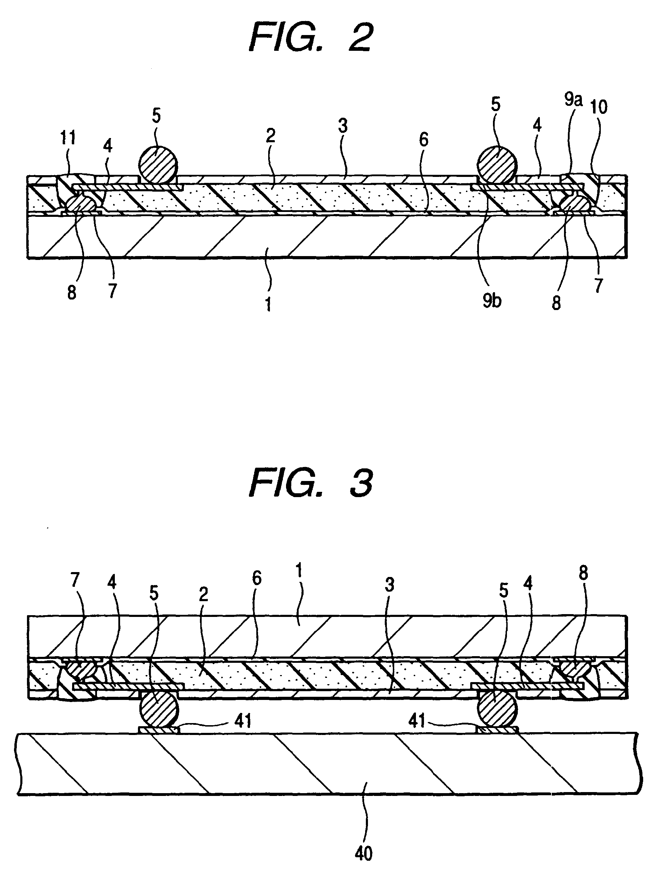

Fig. 1 is a perspective view showing a CSP (Chip Size Package) according to this embodiment; Fig. 2 is a section of the CSP; and Fig. 3 is a section of the CSP which is packaged over a printed-circuit board.

The CSP of this embodiment is constructed to mainly include: a semiconductor chip 1; an elastomer 2 covering the principal face (or element forming face) of the semiconductor chip 1; an insulating tape 3 overlying the elastomer 2; a plurality of wires 4 formed on one face (or lower face) of the insulating tape 3; and solder bumps 5 connected with the one-end portions of those wires 4.

The semiconductor chip 1 is made of single crystalline silicon having a thickness of about 0.28 to 0.55 mm, for example, and a surface protecting film (or passivation film) 6, as made of an insulating film such as a silicon oxide film or a silicon nitride film, is formed over the principal face of the semiconductor chip 1. In the peripheral edge portion of the semiconductor chip 1, there are formed a plurality of bonding pads 7. These bonding pads 7 are arranged in one line along the four sides of the semiconductor chip 1, and Au bumps 8 for connecting the bonding pads 7 and the wires 4 electrically are jointed to the surfaces of the individual bonding pads 7.

The elastomer 2 covering the principal face of the semiconductor chip 1 is made, for example, of a photoresist of low elasticity applied to the principal face of the semiconductor chip 1 or a photosensitive film of low elasticity laminated on the principal face of the semiconductor chip 1, and is given a film thickness of about 0.005 to 0.15 mm, preferably about 0.01 to 0.1 mm, or more preferably about 0.02 to 0.1 mm. On the other hand, the longitudinal x transverse size of this elastomer 2 is equal to those of the semiconductor chip 1.

The elastomer 2 is constructed of a single-layer structure of a high molecular elastomer such as silicone rubber, epoxy, polyimide, urethane or fluorine-contained elastomer, or a laminated structure having two to three laminated layers of such elastomers. This elastomer 2 is formed to damp the stress, as caused due to the difference in the coefficient of thermal expansion between the semiconductor chip 1 and the packaging substrate, and to protect the chip surface, and is given a modulus of elasticity of about 1 to 5,000 MPa, preferably about 1 to 1,000 MPa or more preferably about 1 to 500 MPa.

In the peripheral edge portion of the elastomer 2, there are formed a plurality of through holes 10. These through holes 10 are positioned to correspond to the bonding pads 7 which are formed in the principal face of the semiconductor chip 1. In other words, the through holes 10 are formed just over the corresponding bonding pads 7, and the Au bumps 8 are arranged in the through holes 10.

The insulating tape 3, as arranged over the elastomer 2, is made of a resin such as polyimide, glass epoxy or polyester and is given a thickness of about 0.05 to 0.125 mm and a longitudinal x transverse size equal to that of the semiconductor chip 1. This insulating tape 3 is jointed by means of an adhesive to the upper face of the elastomer 2. The wires 4, as formed on one face of the insulating tape 3, are formed by etching an electrolytic copper foil (or rolled copper foil) adhered to the insulating tape 3, and is plated with Au/Ni, for example, on the surfaces of their two end portions.

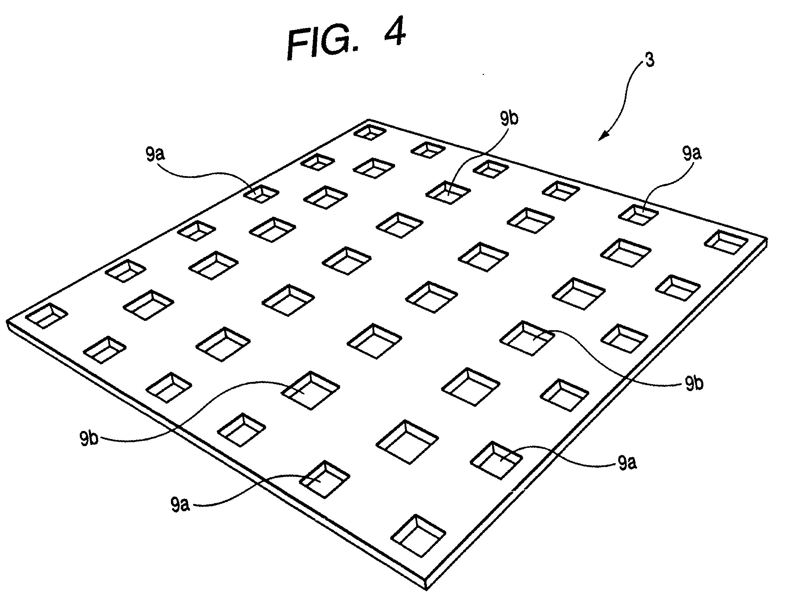

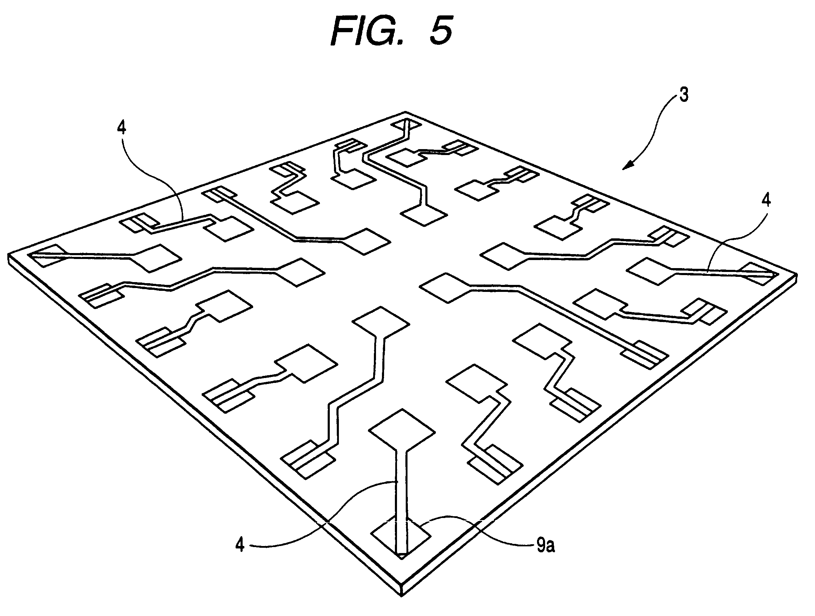

Fig. 4 is a perspective view showing the upper face of the insulating tape 3, and Fig. 5 is a perspective view showing the lower face. In the peripheral edge portion of the insulating tape 3, as shown in Fig. 4, there are formed a plurality of openings 9a. These openings 9a are positioned to correspond to the bonding pads 7 of the semiconductor chip 1 and the through holes 10 of the elastomer 2. In the central portion of the insulating tape 3, on the other hand, there are formed the same number of openings 9b as that of the openings 9a. The openings 9b are arranged longitudinally and transversely in a grid shape. As shown in Fig. 5, there are formed in the lower face of the insulating tape 3 the same number of wires 4 as that of the openings 9a and 9b. Each wire 4 is extended at its one end portion into the corresponding opening 9a and at its other end portion into the corresponding opening 9b.

As shown in Figs. 1 and 2, the one-end portions of the wires 4 are electrically connected with the Au bumps 8 through the through holes 10 formed in the elastomer 2. The through holes 10 are filled therein with a sealer 11 for protecting the connected portions between the wires 4 and the Au bumps 8. This sealer 11 is made of an epoxy resin, for example. With the other end portions of the individual wires 4, on the other hand, there are electrically connected the spherical solder bumps 5. These solder bumps 5 are made of a Pb-Sn eutectic alloy, a solder of high melting point or an Au-plated Ni alloy and are given a diameter of about 0.25 to 0.7 mm.

The CSP thus far described may be packaged in a flip-chip over the printed-circuit board by temporarily fixing, as shown in Fig. 3, the solder bumps 5 on foot prints (or electrodes) 411 of the printed-circuit board 40 by means of a solder paste or flux and subsequently by causing the solder bumps 5 to reflow in a heating furnace.

Since the CSP of the aforementioned embodiment has the elastomer 2 sandwiched between the semiconductor chip 1 and the solder bumps 5, the stress, as generated due to the difference in the thermal expansion coefficient between the semiconductor chip 1 and the printed-circuit board 40, can be damped and absorbed by the elastic deformation of the elastomer 2. This prolongs the temperature cycle lifetime of the solder bumps 5 so that the connection reliability between the CSP and the printed-circuit board 40 can be ensured for a long time. As a result, the printed-circuit board 40 for packaging the CSP of this embodiment need not be made of such an expensive material as is designed to have a coefficient of thermal expansion approximate that of the semiconductor chip 1 but can be made of an inexpensive material (e.g., a glass epoxy resin) having a higher thermal expansion coefficient than that of the semiconductor chip 1.

In the CSP of this embodiment, moreover, the elastomer 2 is formed over the principal face of the semiconductor chip 1, and the insulating tape 3 is jointed to the upper face of the elastomer 2, so that the elastomer 2 and the insulating tape 3 function as protective layers for protecting the principal face of the semiconductor chip 1. Thus, the semiconductor chip 1 need not be provided on its principal face with a separate protective layer of a polyimide resin or an epoxy resin but can be packaged as it is over the printed-circuit board 40.

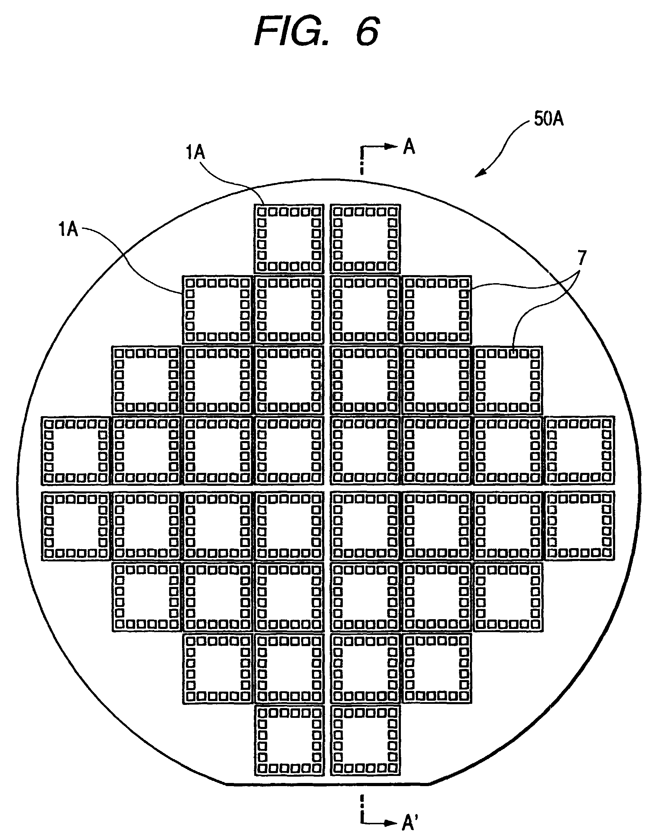

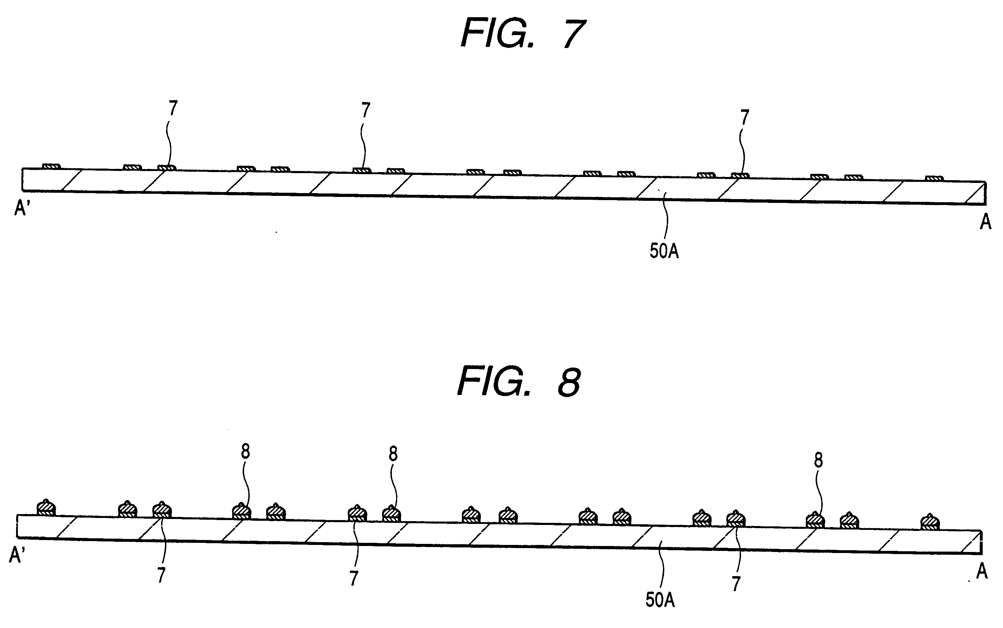

Next, a process for manufacturing the CSP thus constructed will be described in the order of steps with reference to Figs. 6 to 18. Fig. 6 is a top plan view showing the entirety of a semiconductor wafer, and Figs. 7 to 18 are sections taken along line A - A' of Fig. 6.

First of all, there is provided a semiconductor wafer 50A which is made of single crystalline silicon, as shown in Figs. 6 and 7. In each chip area 1A of the principal face of the semiconductor wafer 50A, there is formed in advance a not-shown LSI by the well-known wafer process in which an oxidation, an ion implantation, a diffusion, an insulated film deposition, a conductive film deposition and a photolithography are combined. Moreover, the passivation film 6 at the peripheral edge portion of each chip area 1A is opened to expose a portion of the uppermost layer wires to the outside thereby to form the bonding pads 7. This uppermost layer wires are made of an Al alloy film, for example.

Next, as shown in Fig. 8, the Au bumps 8 are connected to the upper faces of the bonding pads 7 of each chip area 1A. The connections of the Au bumps 8 are performed by the ball bonding method of working the leading ends of Au wires into balls.

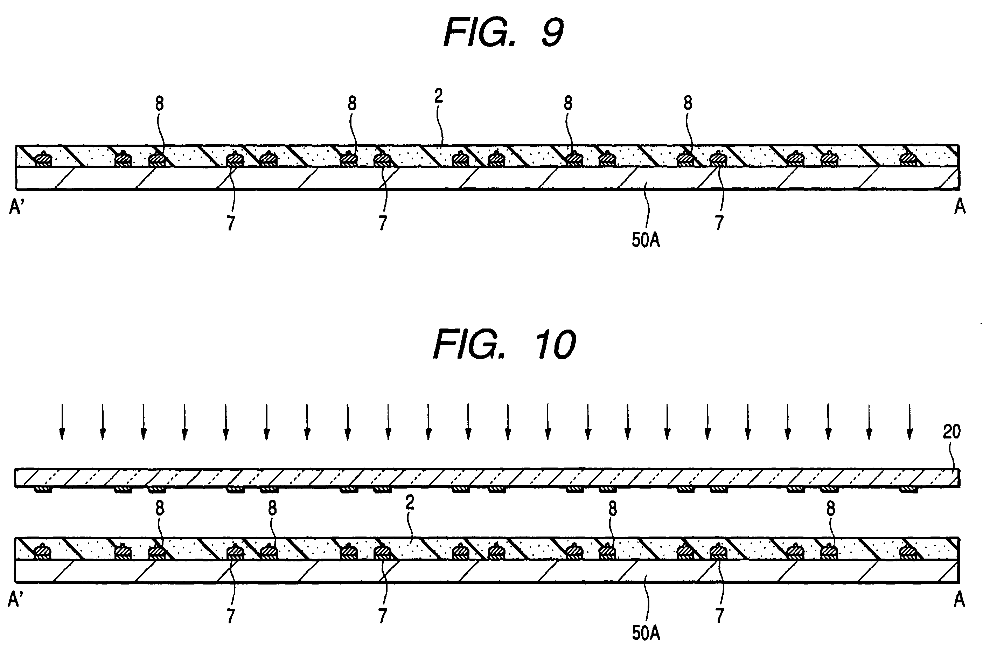

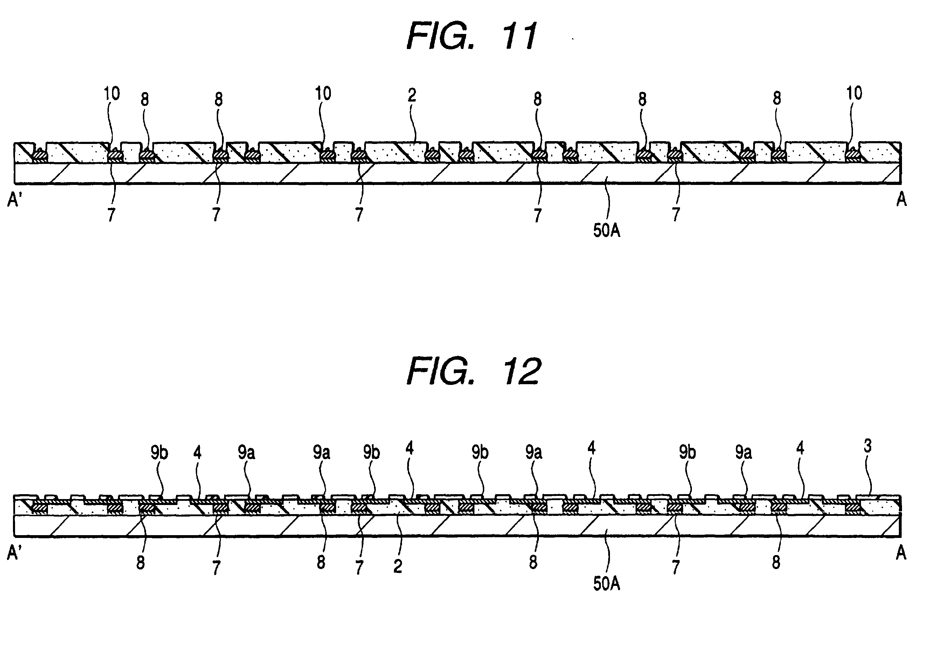

Next, as shown in Fig. 9, the elastomer 2 is formed by spin-coating (or laminating by means of an adhesive) the photosensitive resist (or film) of low elasticity to the principal face of the semiconductor wafer 50A. Next, as shown in Fig. 10, a photo mask 20 is used to expose a predetermined area of the elastomer 2 selectively, and the elastomer 2 is developed to form the through holes 10 just over the bonding pads 7, as shown in Fig. 11, thereby to expose the Au bumps 8. Here, the through holes 10 can also be formed by using the method of irradiating the elastomer 2 with a laser beam having a fine spot diameter.

Next, as shown in Fig. 12, the insulating tape 3 is adhered to the upper face of the elastomer 2 by means of an adhesive. At this time, the openings 9a of the insulating tape 3 and the one-end portions of the wires 4 are accurately positioned over the through holes 10 of the elastomer 2. In order to ensure the close contact between the elastomer 2 and the insulating tape 3, moreover, the insulating tape 3 is applied to the upper face of the elastomer 2 to bury the wires 4 in the elastomer 2 thereby to hold the upper face of the wires 4 and the upper face of the elastomer 2 at a substantially identical level.

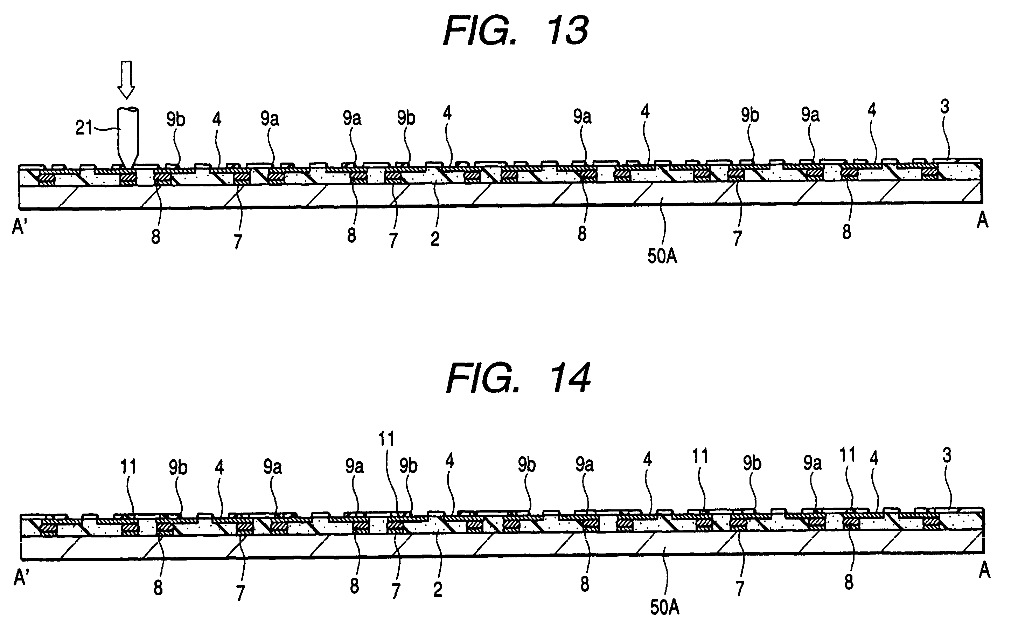

Next, as shown in Fig. 13, the wires 4 and the Au bumps 8 are electrically connected by applying a bonding tool 21, which has been heated to about 500 °C , to one end portion of the wire 4 through the opening 9a of the insulating tape 3. After this, as shown in Fig. 14, the sealer 11 is poured into the through holes 10 of the elastomer 2 through the openings 9a of the insulating tape 3 and is then thermally set.

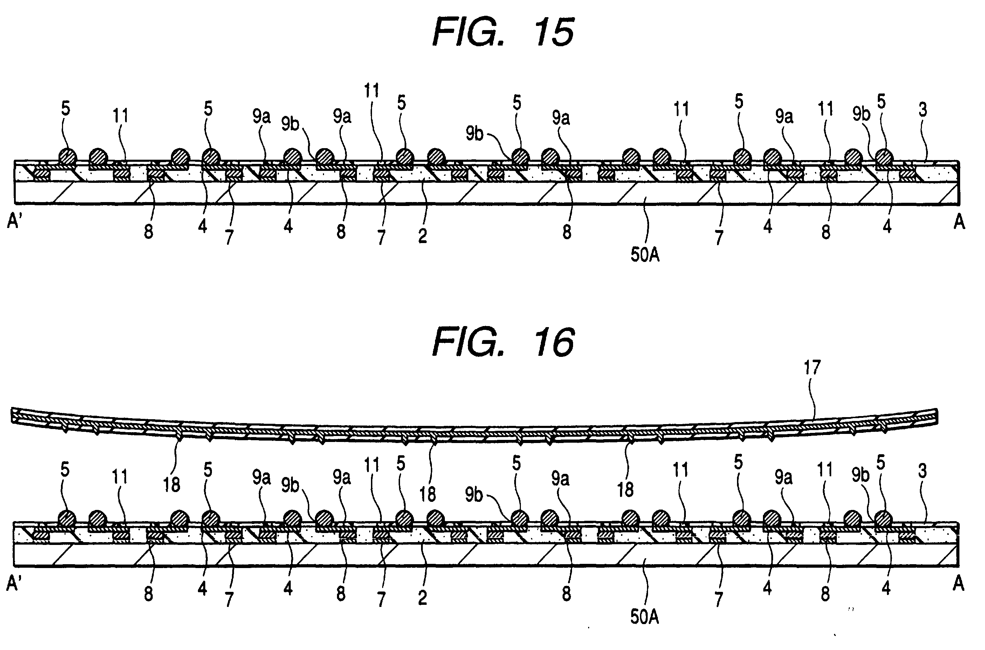

Next, as shown in Fig. 15, the solder bumps 5 are connected to the other end portions of the wires 4, as exposed to the insides of the openings 9b of the insulating tape 3. In order to connect the solder bumps 5 and wires 4, the solder bumps 5, which have been shaped into spherical shapes, are temporarily soldered to the surfaces of the wires 4 by means of a solder paste or flux and are then made to reflow in a heating furnace.

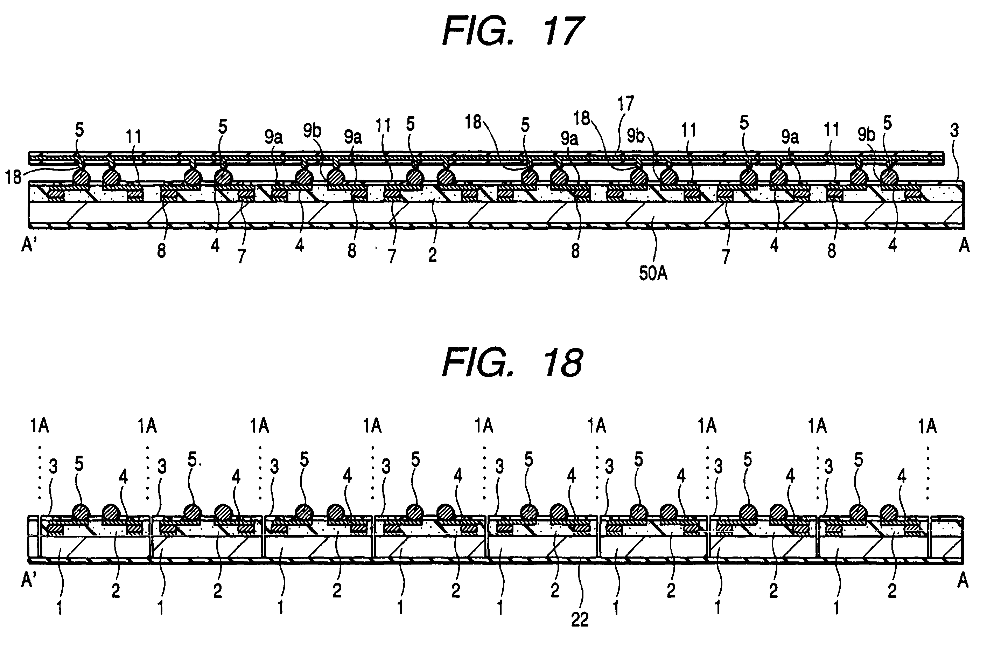

Next, the chip area 1A is tested (for the electric characteristics and the burn-in) in this state. For this testing, there is provided a test jig 17 which has a thin film shape, as shown in Fig. 16. This test jig 17 is constructed to have substantially the same size as that of the semiconductor wafer 50A and has a number of probes 18 on its one face. As shown in Fig. 17, the testing is performed to apply the probes 18 of the test jig 17 to the solder bumps 5 of the chip area 1A thereby to select between the non-defective chip area 1A and the defective chip area 1A.

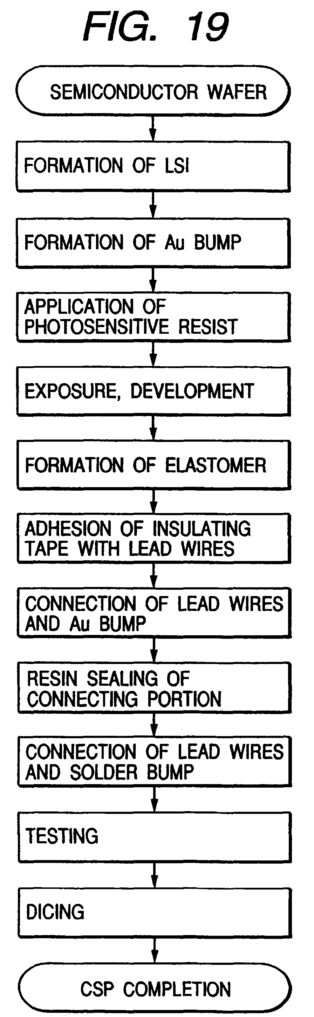

Next, as shown in Fig. 18, a dicing tape 22 is adhered to the back face of the semiconductor wafer 50A. After this, the boundary (or scribe lines) of each chip area 1A is diced and divided into the semiconductor chip 1 so that the aforementioned CSP shown in Figs. 1 and 2 is completed. Fig. 19 is an entire flow chart of the process for manufacturing the CSP.

Thus, in the process for manufacturing the CSP of this embodiment, all the steps to connect the Au bumps 8 to the upper faces of the bonding pads 7 of the chip area 1A and to test the solder bumps 5, as connected with the wires 4 of the insulating tape 3, by applying the probe 18 to the solder bumps 5 are performed in the wafer process (i.e., the so-called "pre-process"). After this, the semiconductor wafer 50A is diced to produce the semiconductor chip 1 of the CSP structure from the chip area 1A. Specifically, this semiconductor chip 1 is covered at its principal face with the elastomer 2 and the insulating tape 3 at the time of dicing the semiconductor wafer 50A and is divided by selection into the non-defective products and the defective products. As a result, the semiconductor chip 1 can be packaged as it is as the CSP over the printed-circuit board 40. This substantially eliminates such packaging process (or the so-called "post-process") of the semiconductor chip 1 as has been performed in the prior art after the dicing of the semiconductor wafer 50A.

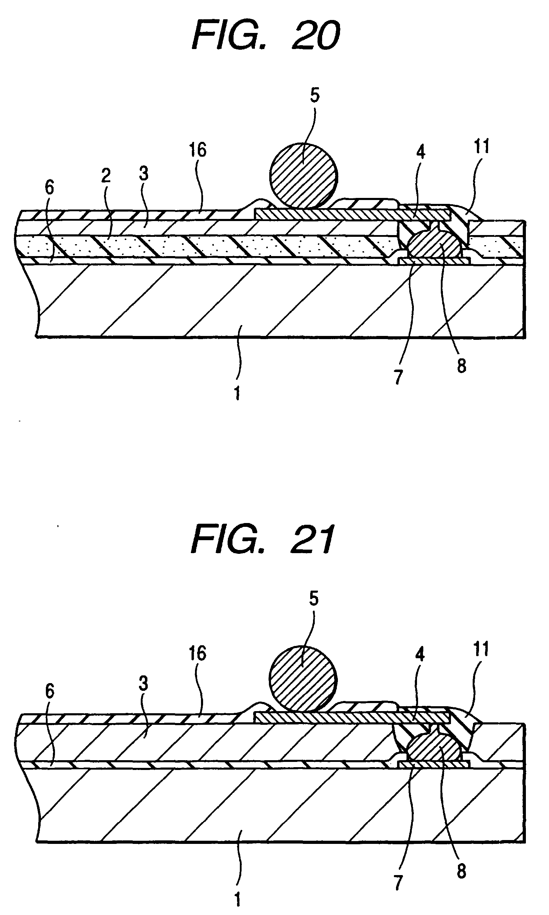

Here in the CSP shown in Figs. 1 and 2, the wires 4 are arranged on the lower face side of the insulating tape 3 which is adhered to the upper face of the elastomer 2 but may be arranged on the upper face side of the insulating tape 3, for example, as shown in Fig. 20. Thus, the contact area between the elastomer 2 and the insulating tape 3 is enlarged to improve their contact thereby to eliminate the works for burying the wires 4 in the elastomer 2. In this modification, the surfaces of the wires 4 excepting the ares (or terminal portions), with which the solder bumps 5 are connected, are coated with a solder resist 16.

In another mode of the CSP, moreover, the insulating tape 3 having a modulus of elasticity capable of damping the stress to be generated between the chips and the substrate may be adhered directly to the principal face of the semiconductor chip 1, as in Fig. 21. In this case, the elastomer 2 can be eliminated to reduce the numbers of parts of and manufacture steps of the CSP. Since the elastomer 2 is not used, moreover, the flatness of the principal face of the semiconductor chip 1 is accordingly improved to reduce the dispersion in the height of the solder bumps 5 to be connected with the wires 4 thereby to further improve the connection reliability between the CSP and the printed-circuit board 40.

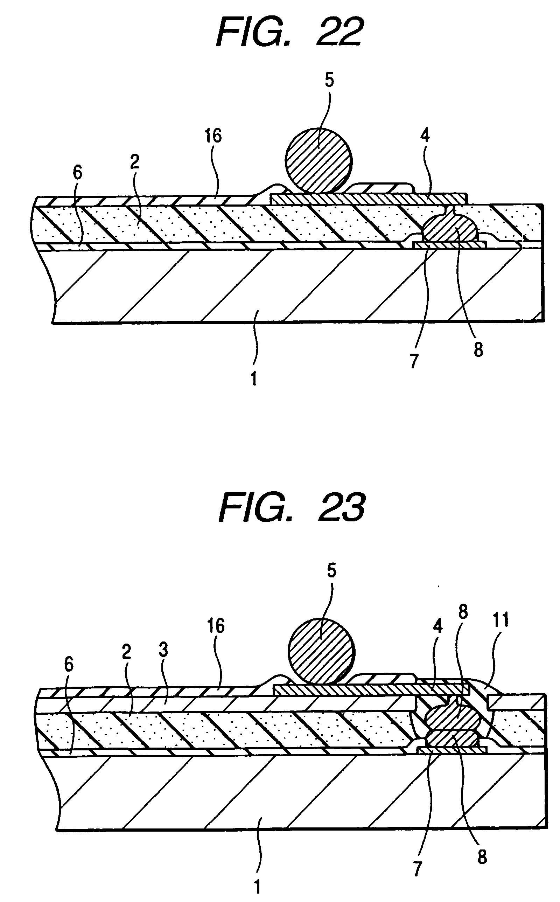

In place of the means for using the insulating tape 3 having the wires 4, the wires 4 may be formed directly over the surface of the elastomer 2, for example, as shown in Fig. 22. In order to form the wires 4, the elastomer 2 is formed over the principal face of the semiconductor chip 1 by the aforementioned method, for example, and a metal film is then deposited over the surface of the elastomer 2 by the electroless plating or deposition method. Next, the metal film is patterned by using the photolithography technique. In this case, too, the numbers of the parts of and manufacture steps of the CSP can be reduced as in the foregoing mode, and the flatness of the chip surface can be improved.

In still another mode of the CSP, the Au bumps 8 to be connected on the bonding pads 7 may be given a multistage structure, for example, as shown in Fig. 23. Then, the diameter of the Au bumps 8 in the height direction can be effectively increased to give a stress absorbing ability of some extent to the Au bumps 8 themselves.

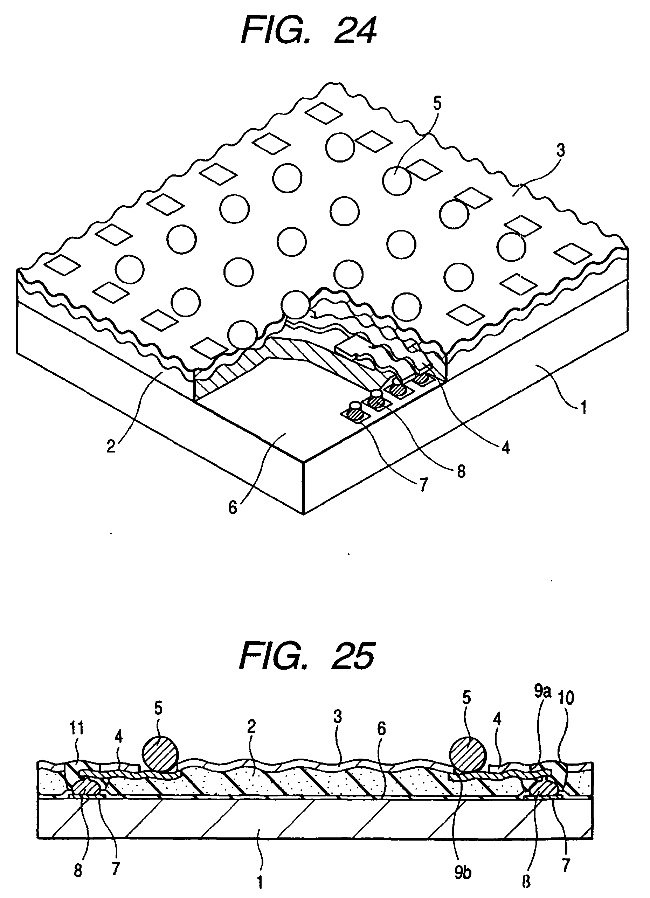

In still another mode of the CSP, as shown in Fig. 24 (presenting a perspective view) and Fig. 25 (presenting a section), the surface of the elastomer 2 (and/or the insulating tape 3) may be undulated to make the wires 4 extendible. Then, a portion of the stress to be applied to the solder bumps 5 can be damped and absorbed by the extension/contraction of the wires 4 thereby to further improve the connection reliability between the CSP and the printed-circuit board 40.

### Embodiment 2

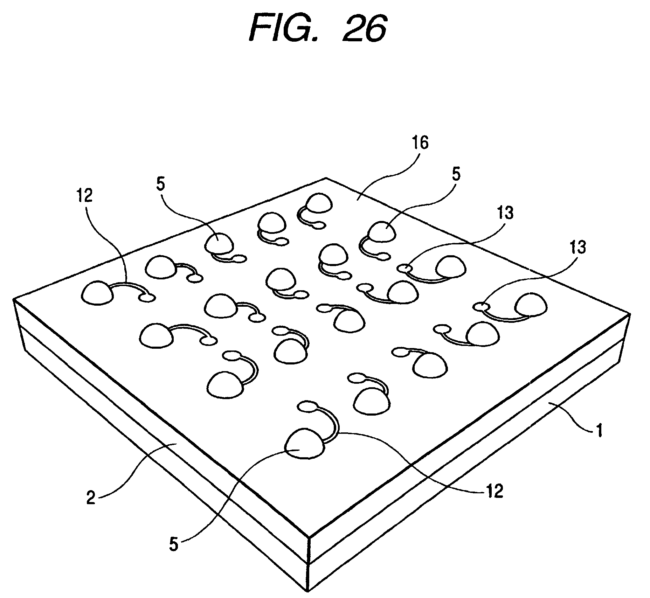

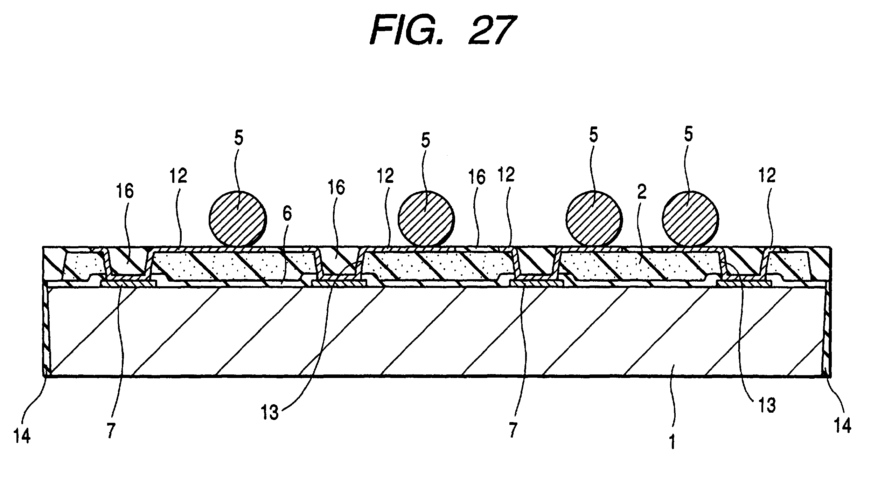

Fig. 26 is a perspective view shoving a CSP according to this embodiment, and Fig. 27 is a section of this CSP.

In the CSP of this embodiment, the principal face of the semiconductor chip 1 is coated with the elastomer 2, and wires 12 are formed over the upper face of the elastomer 2. This elastomer 2 is made of a photosensitive resist (or film) of low elasticity similar to that employed in the foregoing Embodiment 1, and the wires 12 formed over the upper face of the elastomer 2 are electrically connected at their one-end portions with the bonding pads 7 of the semiconductor chip 1 through through holes 13 formed in the elastomer 2. The other end portions of the wires 12 are connected to the solder bumps 5 similar to those of the Embodiment 1. Here, the bonding pads 7 are arranged not in the peripheral edge portion of the principal face of the semiconductor chip 1 but, like the solder bumps 5, in a grid shape in the central portion of the principal face of the semiconductor chip 1.

As shown in Fig. 26, the wires 12 over the upper face of the elastomer 2 are not in a straight pattern but in an arcuate pattern in their paths from the through holes 13 to the terminal portions (with which the solder bumps 5 are connected). As shown in Fig. 27, moreover, the wires 12 are coated, on their surfaces excepting the terminal portions, with the solder resist 16. Still moreover, the semiconductor chip 1 is coated on its side faces with the sealer 14 of an epoxy resin so that a foreign substance such as moisture is hard to enter the chip inside from the outside through the side faces.

According to the CSP of this embodiment in which the wires 12 over the upper face of the elastomer 2 are given the arcuate pattern, the stress to be generated between the chip and the substrate is absorbed and damped not by the elastic deformation of the elastomer 2 but also the extension/contraction of the wires 12 so that the connection reliability between the CSP and the substrate is further improved. Since the wires 12 are given the stress absorbing ability, moreover, the connection reliability between the CSP and the substrate can be ensured even if the elastomer 2 is thinned (to have a lower stress absorbing ability), so that a thin CSP can be realized.

In the CSP of this embodiment thus constructed, the Au bumps 8 are not bonded to the upper faces of the bonding pads 7 of the semiconductor chip 1 so that no strong impact is applied to the bonding pads 7 in the course of the manufacture process. This makes it possible to arrange the bonding pads 7 in any area of the principal face of the semiconductor chip 1 including the element forming area. Since no consideration need be given to the height of the Au bumps 8 when the elastomer 2 is to be formed over the principal face of the semiconductor chip 1, moreover, the elastomer 2 can be easily made thin.

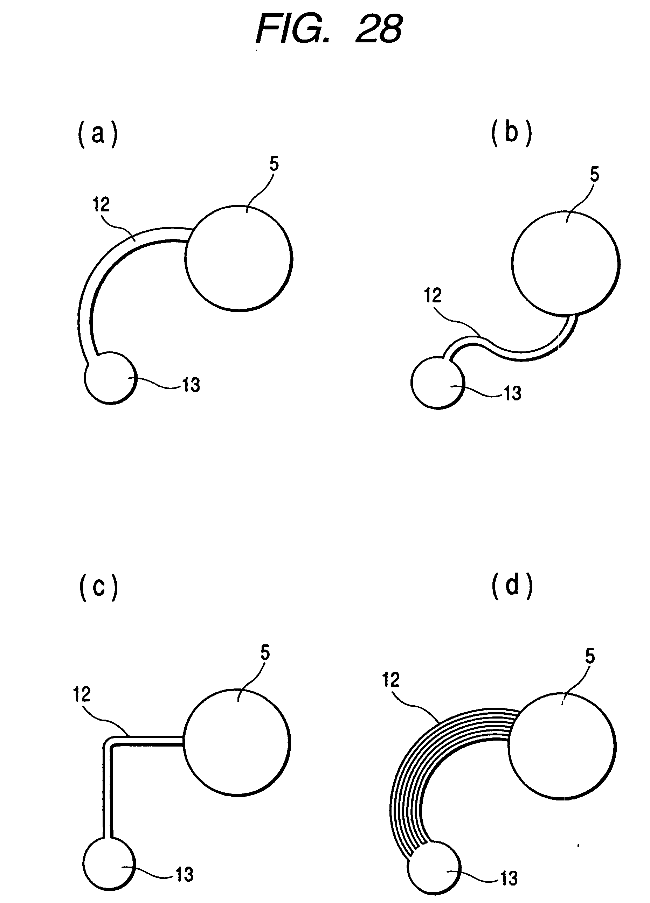

Here, the wires 12 can take not only the arcuate pattern, as shown at (a) in Fig. 28, but also any curved pattern such as an S-shaped pattern, as shown at (b) in Fig. 28, or an L-shaped pattern, as shown at (c) in Fig. 28. If the wires 12 are formed at their curved portions of a plurality of fine wiring patterns, as shown at (d) in Fig. 28, the extendibility of the curved portions is further improved, and the wiring resistance is reduced. Even if one wire is broken, moreover, the conduction can be retained through the remaining wires. When the adjoining fine wires are then connected at some points into a mesh pattern, still moreover, the increase in the wiring resistance can be minimized even if the fine wires are broken at one point.

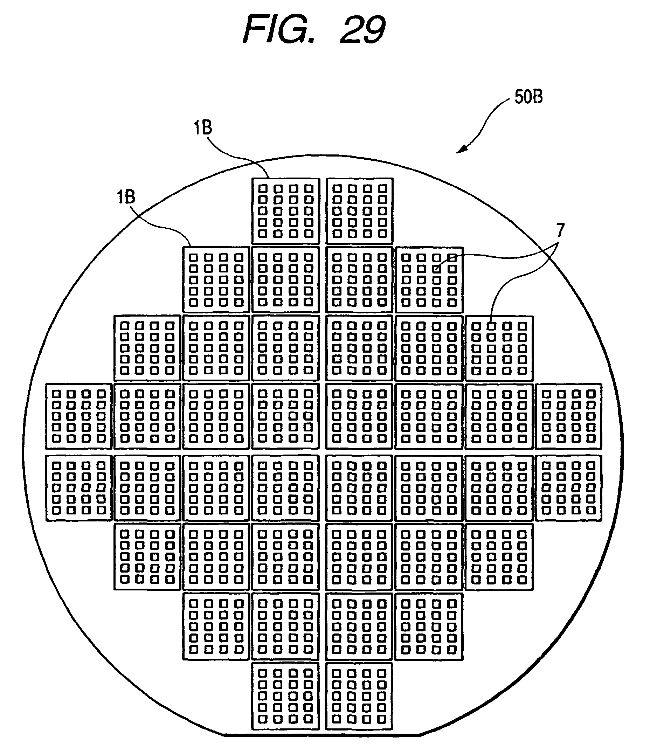

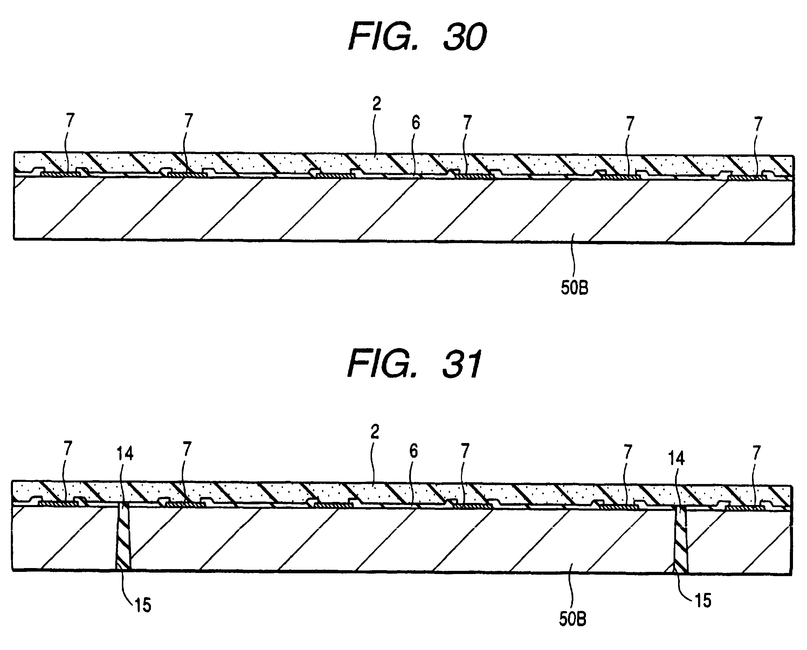

Next, a process for manufacturing the CSP of this embodiment will be described in the order of its steps with reference to Figs. 29 to 38. Fig. 29 is a top plan view showing the entirety of the semiconductor wafer, and Figs. 30 and 31 are sections showing about one chip area of the semiconductor wafer.

First of all, there is provided a semiconductor wafer 50B which is made of single crystalline silicon, as shown in Fig. 29. In each chip area 1B of the principal face of the semiconductor wafer 50B, there is formed in advance a not-shown LSI. At the central portion of each chip area 1B, moreover, there are formed in a grid shape a plurality of bonding pads 7 which are made of an Al alloy film, for example.

Next, as shown in Fig. 30, the elastomer 2 is formed by spin-coating (or laminating by means of an adhesive) the photosensitive resist (or film) of low elasticity to the principal face of the semiconductor wafer 50B. After this, as shown in Fig. 31, the boundary (or scribe lines) between back face side of the semiconductor wafer 50B and the chip area 1B is etched to form slits 15 reaching the elastomer 2. Next, the insides of the slits 15 are charged with a sealer 14 from the back face side thereby to insulate the adjoining chip areas 1B electrically. This sealer 14 acts as a protective layer for the side faces of the semiconductor chip 1 after the chip areas 1B are diced and divided at a subsequent step into semiconductor chips 1.

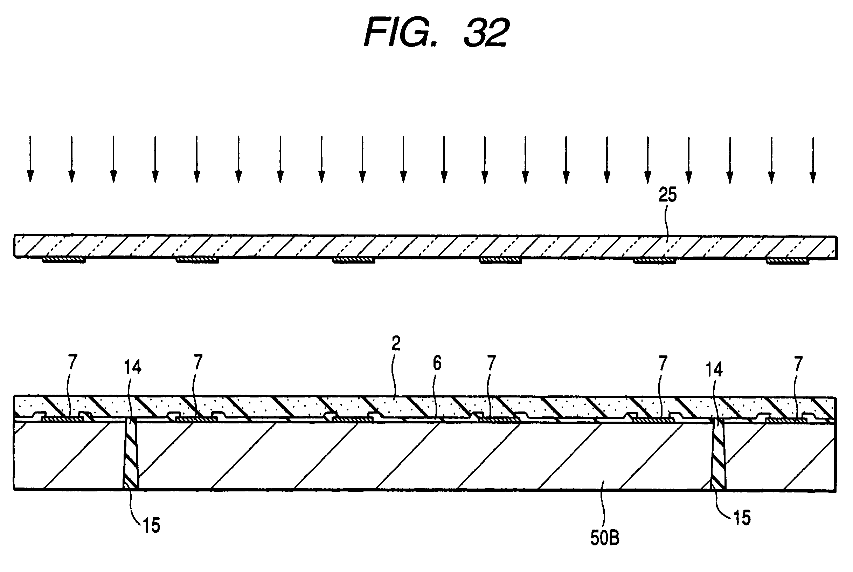

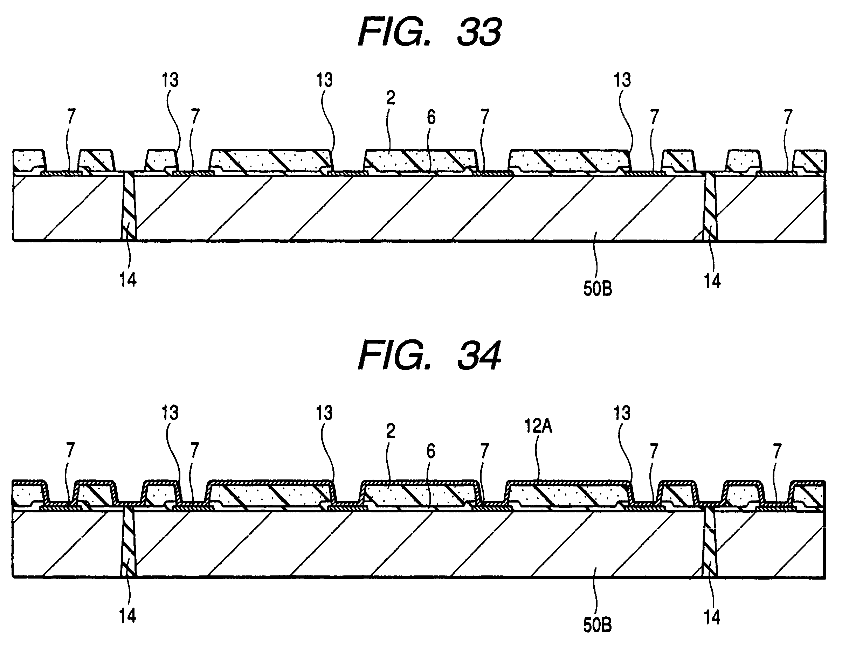

As shown in Fig. 32, a photo mask 25 is used to expose a predetermined area of the elastomer 2 selectively, and the elastomer 2 is developed to form the through holes 13, as shown in Fig. 33, thereby to expose the bonding pads 7. If the elastomer 2 in the vicinity of the scribe lines is removed together, the final step of dicing is facilitated.

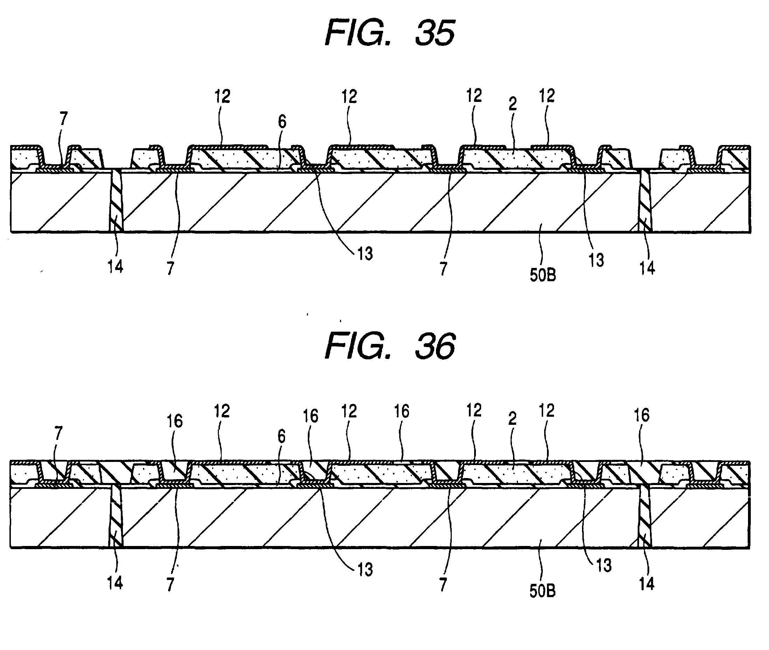

Next, as shown in Fig. 34, a plated layer 12A of Au or Cu is deposited on the surface of the elastomer 2 including the insides of the through holes 13 and is then patterned by the etching treatment using a photoresist film as the mask to form the wires 12 which are connected at their one-end portions with the bonding pads 7 and extended at their other end portions over the upper face of the elastomer 2 through the through holes 13, as shown in Fig. 35. At this time, the wires 12 over the upper face of the elastomer 2 are formed in the curved patterns, as shown in Fig. 26 or 28.

Next, as shown in Fig. 36, the surface of the elastomer 2 including the insides of the through holes 13 is coated with the solder resist 16 so that the surfaces of the wires 12 excepting the terminal portions, with which the solder bumps 5 are connected, are coated with the solder resist 16. On the other hand, the solder resist 16, as buried in the through holes 13, functions as a sealer for protecting the connection portions between the bonding pads 7 and the wires 12.

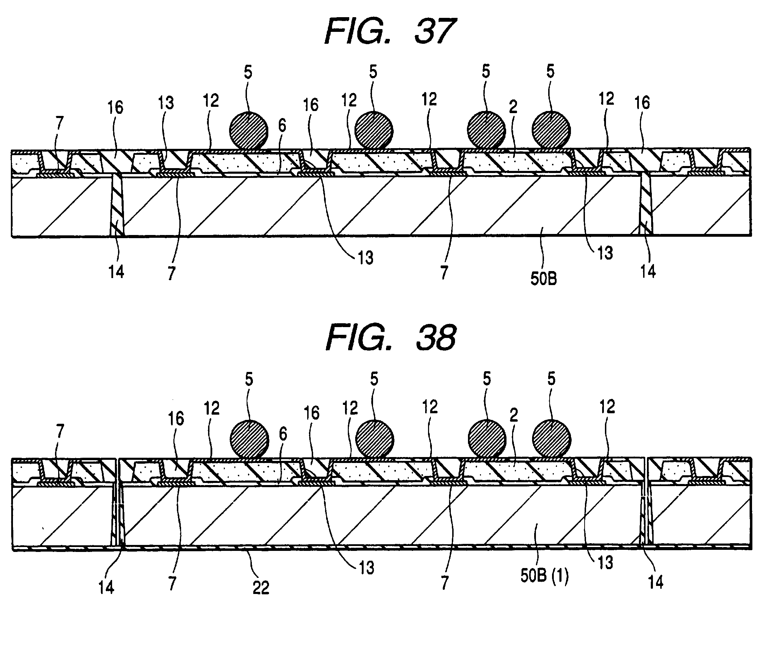

Next, as shown in Fig. 37, the solder bumps 5 are connected to the end portions of the wires 12. In order to connect the solder bump 5, the solder bumps 5, which have been shaped into spherical shapes, as in the foregoing Embodiment 1, may be temporarily soldered to the wires 12 by means of a solder paste or flux and then made to reflow in a heating furnace.

Next, the testing (for the electric characteristics and the burn-in) is performed in this state to select between the non-defective chip area 1B and the defective chip area 1B. After this, as shown in Fig. 38, the dicing tape 22 is adhered to the back face of the semiconductor wafer 50B, and the boundary (or scribe lines) of each chip area 1B is diced and divided into the semiconductor chip 1 so that the CSP of this embodiment is completed.

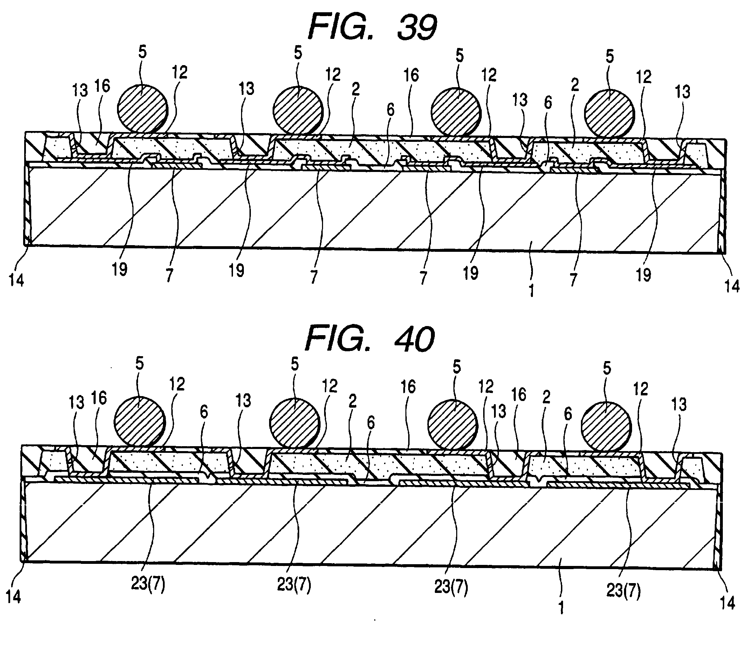

Here, in the CSP shown in Figs. 26 and 27, the through holes 13 are arranged just over the bonding pads 7. As shown in Fig. 39, however, the through holes 13 may be arranged in areas apart from the bonding pads 7 so that wires 19 formed over the surface protecting film (or passivation film) 6 may be lead from the bonding pads 7 to the through holes 13. In place of the means for forming the wires 19 over the surface protecting film 6, on the other hand, the through holes 13 may be formed in the elastomer 2 and the surface protecting film 6 apart from the bonding pads 7, as shown in Fig. 40, so that wires 23, as formed of the conductive film (e.g., an Al alloy film) belonging to the same layer as the bonding pads 7, may be lead to the through holes 13. Here in these modes, as in the Embodiment 1, there can be employed the semiconductor chip 1 in which the bonding pads 7 are arranged in the peripheral edge portion.

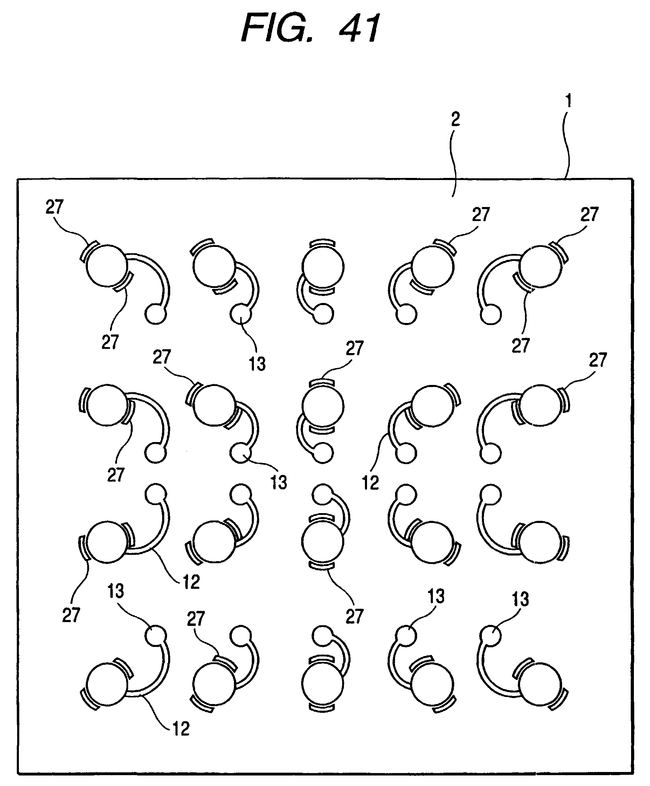

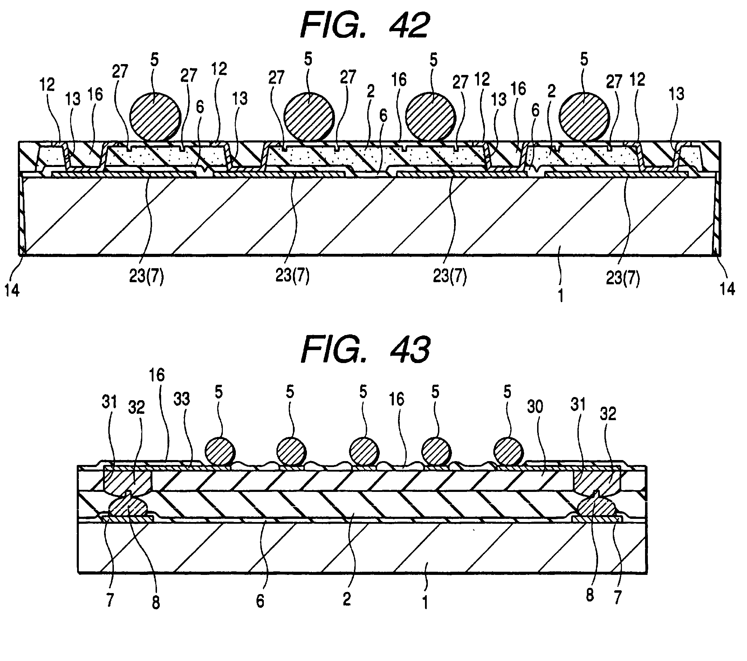

In another mode of the CSP, moreover, slits 27 may be formed in the elastomer 2 near the terminal portions to be connected with the solder bumps 5, as shown in Fig. 41 (presenting a top plan view) and Fig. 42 (presenting a section). Thus, the elastomer 2 in the vicinity of the terminals portions is made liable to elastically deform by the extension/contraction of the slits 27 so that the stress to be applied to the solder bumps 5 can be further reduced. At this time, the slits 27 are paired across each terminal portion, as shown, such that one of them is arranged at the center side of the chip whereas the other is arranged at the opposite side. Moreover, the longitudinal direction of each slit 27 is oriented to intersect the direction joining the terminal portion and the center portion of the semiconductor chip 1 at a right angle. Thus, it is possible to effectively damp the stress component which is caused by the expansion and shrinkage of the semiconductor chip 1 in the direction joining the terminal portion and the chip center portion.

In the case of the CSP in which an insulating tape 30 is laminated on the upper face of the elastomer 2, as shown in Fig. 43, wires 33, as formed over the insulating tape 30, may be formed in the curved pattern, as shown in Fig. 28.

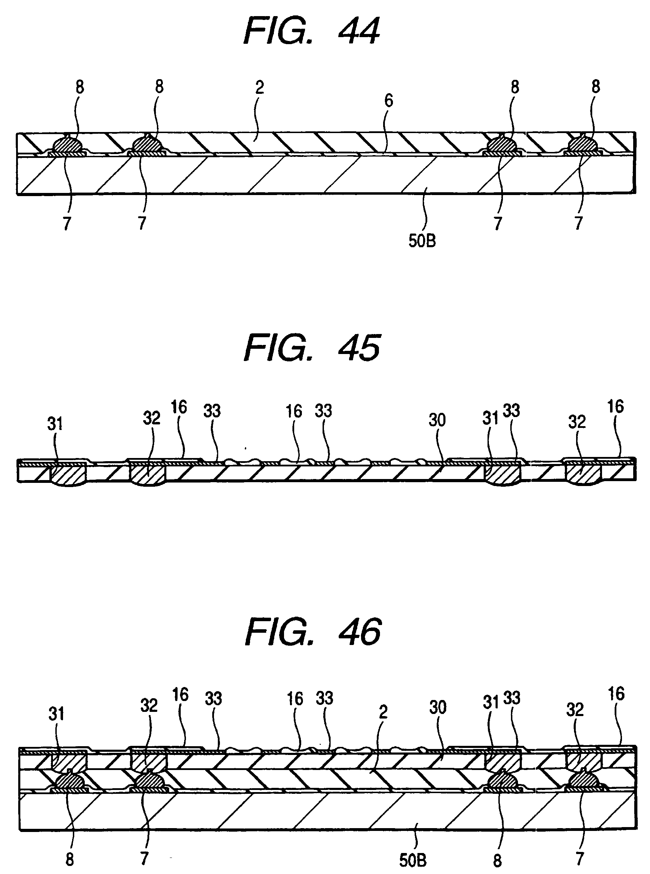

The CSP shown in Fig. 43 is manufactured by the following process, for example. First of all, as shown in Fig. 44, the Au bumps 8 are connected to the upper faces of the bonding pads 7 of the semiconductor wafer 50B. After this, the elastomer 2 is spin-coated (or laminated with an adhesive) to the principal face of the semiconductor wafer 50B. Independently of this, there is provided the insulating tape 30, as shown in Fig. 45. The wires 33, as formed over one face (or upper face) of the insulating tape 30, are connected at their one-end portions with through holes 31 which are opened in the insulating tape 30. In the insides of these through holes 31, moreover, there is formed a plated layer 32 which is partially protruded to the lower face side of the insulating tape 30. The wires 33 are coated, on their surfaces excepting the areas (or terminal portions) with which the solder bumps 5 are connected at a later step, with the solder resist 16.

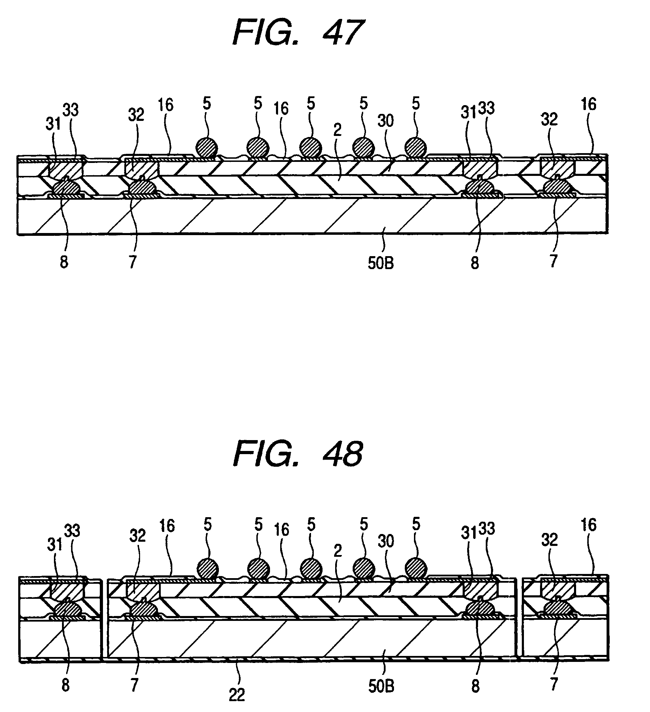

Next, as shown in Fig. 46, the insulating tape 30 is laminated on the upper face of the elastomer 2 by means of an adhesive to electrically connect the Au bumps 8 over the bonding pads 7 and the plated layer 32 in the through holes 31. After this, as shown in Fig. 47, the solder bumps 5 are connected with the one-end portions (or terminal portions) of the wires 33 formed over the upper face of the insulating tape 30.

Next, the testing (for the electric characteristics and the burn-in) is performed in this state. After this, as shown in Fig. 48, the dicing tape 22 is adhered to the back face of the semiconductor wafer 50B. Next, the boundary (or scribe lines) of each chip area 1B is diced and divided into a plurality of semiconductor chips 1 to manufacture the CSP shown in Fig. 43.

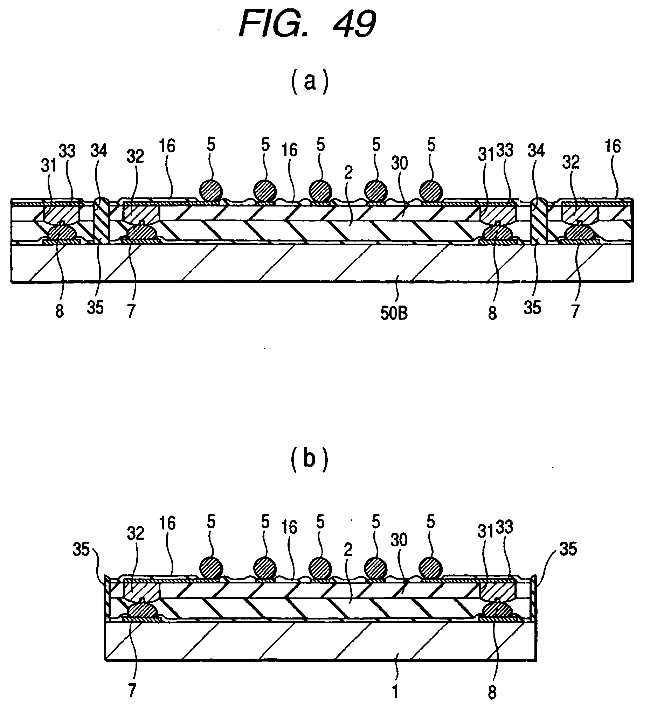

In another mode of the CSP, as shown in at (a) in Fig. 49, slits 34 may be formed in the elastomer 2 at the boundary of the chip area 1B and charged therein with a sealer 35 made of a harder resin than that of the elastomer 2. As shown at (b) in Fig. 49, the sealer 35 functions as the protective layer for the side faces of the semiconductor chip 1 after the boundary of the chip area 1B was diced. Because made harder than the elastomer 2, the sealer 35 also has a function to prevent the elastomer 2 from being excessively deformed at the dicing time.

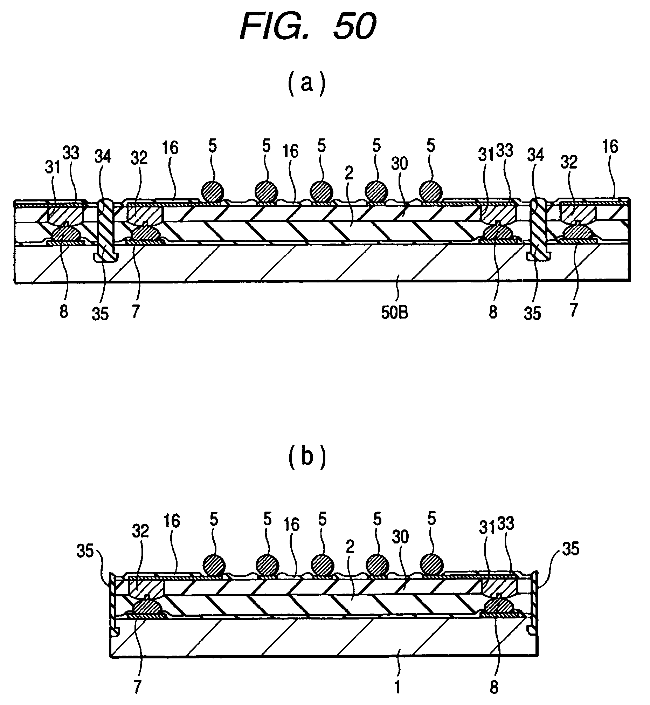

In still another mode of the CSP, as shown at (a) in Fig. 50, the slits 34 may be made so deep that their bottoms may reach the inside of the semiconductor wafer 50B. Then, it is possible to enhance the function of the sealer 35 to protect the side faces of the semiconductor chip 1. At this time, the sealer 35 is made hard (as shown at (b) in Fig. 50) to leave the side faces of the semiconductor chip 1 by etching the semiconductor wafer 50B anisotropically to give the slits 34 a larger diameter at their bottom portions than that in the vicinity of the wafer surface.

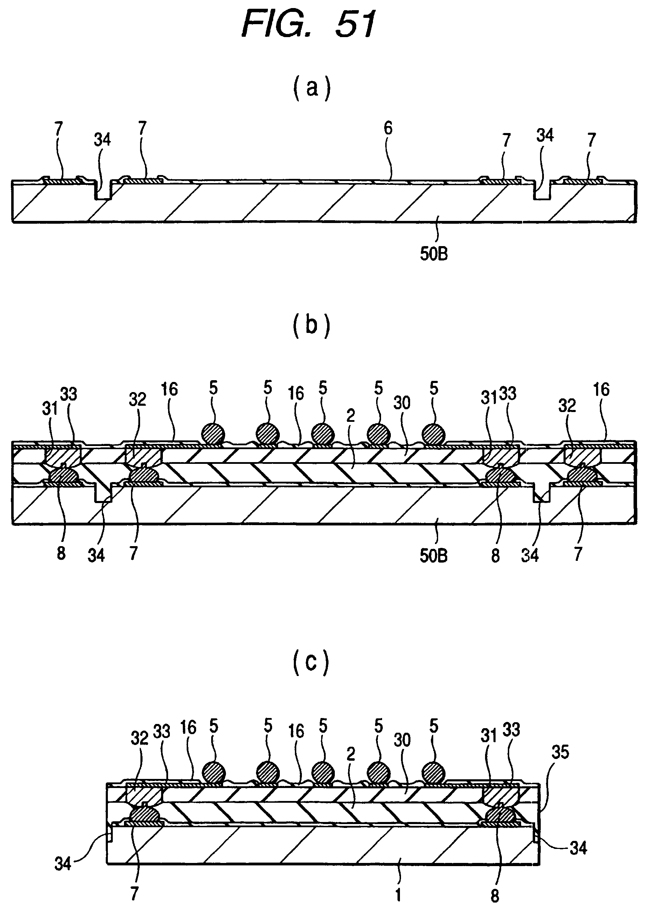

In still another mode of the CSP, as shown at (a) in Fig. 51, the slits 34 may be formed in the semiconductor wafer 50B at the boundary of the chip area 1B. After this, as shown at (b) in Fig. 51, the elastomer 2 may be applied to the principal face of the semiconductor water 50B including the insides of the slits 34. Then, the elastomer 2 can be utilized as the layer for protecting the side faces of the semiconductor chip 1, as shown at (c) in Fig. 51, thereby to eliminate the step of charging the insides of the slits 34 with a sealer of a resin.

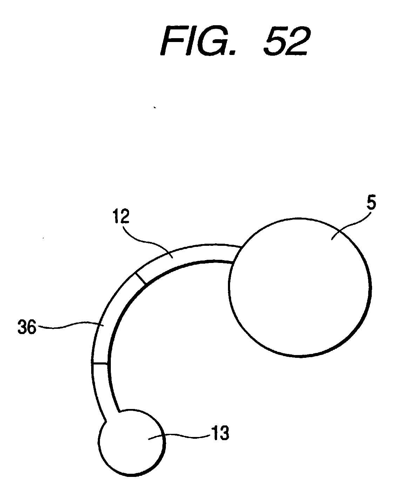

In still another mode of the CSP, as shown in Fig. 52, the wires 12, as formed over the upper face of the elastomer or over one face of the insulating tape, may be used at least partially as a fuse 36. Then, the defective chip area, where a defect of short circuit is found out by the electric characteristic test, can be eliminated by blowing the fuse 36, as formed in the defective chip area, before or during the burn-in.

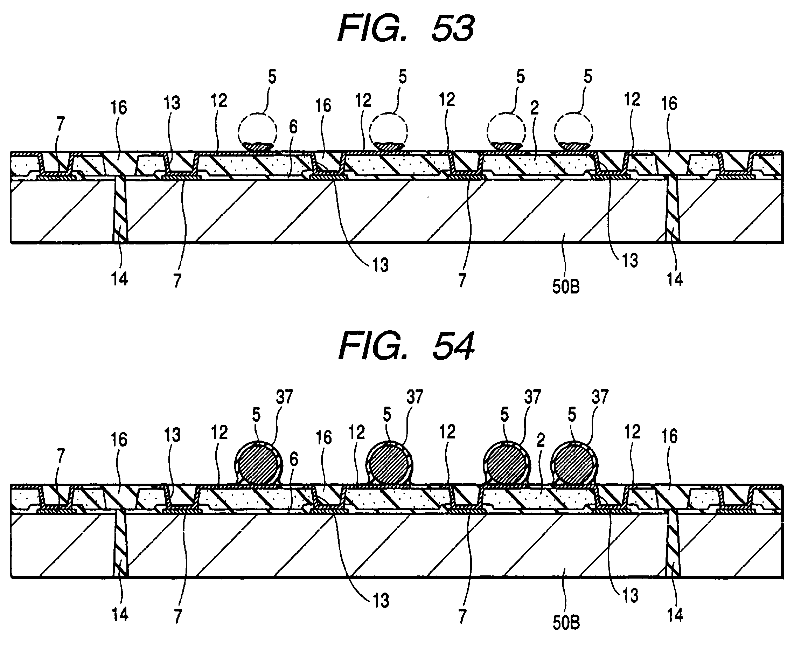

In place of the aforementioned means for utilizing the wires 12 as the fuse 36, moreover, the conduction pins of the tester or the burn-in device can be kept away from the contact with the solder bumps 5 thereby to eliminate the defective chip area 1B, either by scraping off the solder bumps 5 of the chip area 1B, of which the defect of a short circuit is found out by the electric characteristic test, as shown in Fig. 53, or by coating the surfaces of the be of the chip area 1B, as found out defective, with an insulating layer 37 of a resin, as shown in Fig. 54.

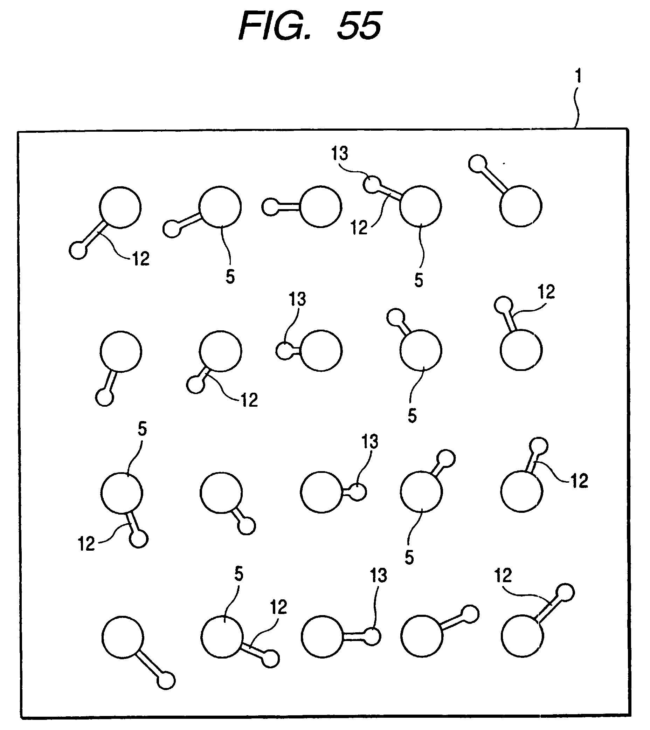

Fig. 55 shows a mode, in which the wires 12 formed over the elastomer 2 are oriented to intersect at a right angle the direction joining the solder bumps 5 connected with the wires 12 and the center of the semiconductor chip 1 and in which the wires 12 arranged in the peripheral edge portion of the semiconductor chip 1 are longer than the wires 12 arranged at the central portion of the semiconductor chip 1. Then, the stress to be applied to the solder bumps 5 due to the relative positional displacement between the solder bumps 5 and the wires 12 is homogenized to equalize the connection lifetimes of the solder bumps 5 all over the chip thereby to improve the connection reliability of the solder bumps 5.

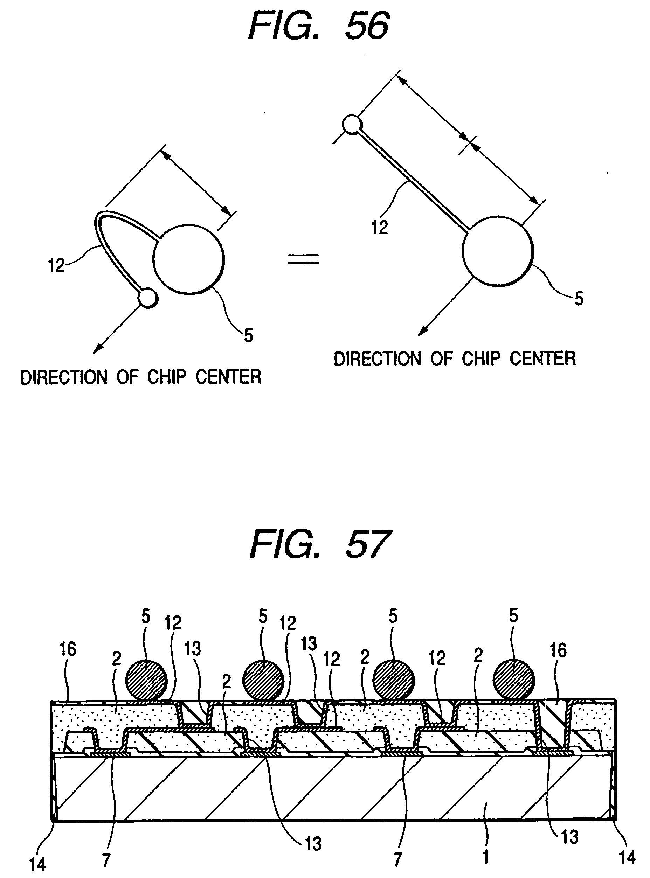

In this mode, the wires 12 need not always have the straight pattern, but, as in Fig. 56, their components, as taken in the direction perpendicular to the chip center direction, may become longer, when accumulated, in proportion to the distance from the chip center.

Although our invention has been specifically described on the basis of its embodiments, it should not be limited thereto but can naturally be modified in various manners without departing from the gist thereof.

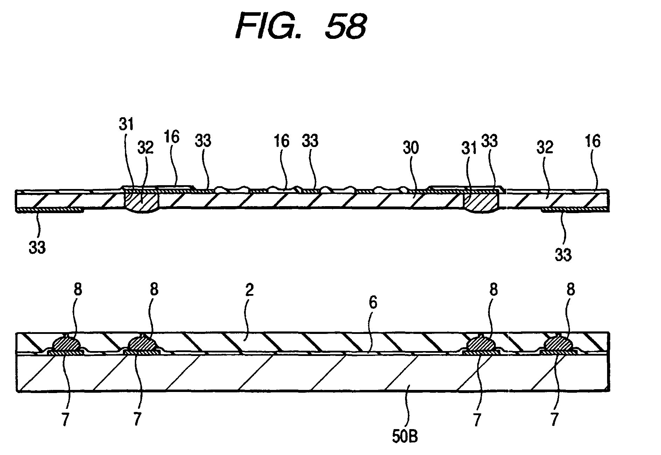

As shown in Fig. 57, for example, the wires 12 to be formed over the elastomer 2 jointed to the principal face of the semiconductor chip 1 may be made to have a multi-layered structure. In this modification, moreover, the wires 12 for the power supply and the wires 12 for the signals may be arranged in the different layers of the elastomer 2 so as to reduce the noises. When the insulating tape 3 is jointed to the upper face of the elastomer 2, moreover, an insulating tape 3 with the wires 33 formed on its two faces, may be used as shown in Fig. 58.

### INDUSTRIAL APPLICABILITY

According to the invention, it is possible to manufacture at a low cost the CSP which can, by using the elastic deformation of the elastomer or the extension/contraction of the wires, damp and absorb the stress to be applied to the bump electrodes due to the difference in the coefficient of thermal expansion between the semiconductor chip and the substrate. This makes it possible to provide a CSP which is suitably used in a small, light-weight electronic device such as a portable information terminal device including a portable telephone, PDA and HPC.

## Claims

1. A semiconductor device characterized: in that an elastomer layer is formed over a plurality of semiconductor elements and bonding pads, which are formed over a plurality of chip areas of the principal face of a semiconductor wafer; and in that bump electrodes are electrically connected at their one-end portions with said bonding pads through through holes opened in said elastomer and at their other end portions with wires arranged over said elastomer layer.

2. A chip size package type semiconductor device comprising semiconductor chips obtained by dividing the chip area of said semiconductor wafer as set forth in Claim 1.

3. A semiconductor device as set forth in Claim 2, characterized in that a protective layer is formed on the side faces of said semiconductor chip.

4. A semiconductor device as set forth in Claim 1, characterized: in that said wires are formed over one face of an insulating tape jointed to the upper face of said elastomer layer; and in that said wires and said bonding pads are electrically connected through Au bumps jointed over said bonding pads.

5. A semiconductor device as set forth in Claim 4, characterized in that a plurality of stages of Au bumps are jointed to the upper faces of said bonding pads.

6. A semiconductor device as set forth in Claim 4, characterized in that said Au bumps are sealed with a resin filled in the through holes of said elastomer layer.

7. A semiconductor device as set forth in Claim 1, characterized in that said elastomer layer is made of either a photosensitive resist applied to the principal face of said semiconductor wafer or a photosensitive film adhered to the principal face of said semiconductor wafer.

8. A semiconductor device as set forth in Claim 1, characterized in that said elastomer layer has a modulus of elasticity of 1 to 5,000 MPa.

9. A semiconductor device as set forth in Claim 1, characterized in that said elastomer layer has a modulus of elasticity of 1 to 1,000 MPa.

10. A semiconductor device as set forth in Claim 1, characterized in that said elastomer layer has a modulus of elasticity of about 1 to 500 MPa.

11. A semiconductor device as set forth in Claim 1, characterized in that said elastomer layer has a film thickness of 0.005 to 0.15 mm.

12. A semiconductor device as set forth in Claim 1, characterized in that said elastomer layer has a film thickness of 0.01 to 0.1 mm.

13. A semiconductor device as set forth in Claim 1, characterized in that said elastomer layer has a film thickness of 0.02 to 0.1 mm.

14. A semiconductor device as set forth in Claim 1, characterized in that said bump electrodes have a spacing larger than that of said bonding pads.

15. A semiconductor device as set forth in Claim 1, characterized in that said elastomer layer has an undulated surface.

16. A semiconductor device as set forth in Claim 1, characterized in that said elastomer layer in the vicinity of said bump electrodes have slits.

17. A semiconductor device as set forth in Claim 1, characterized in that the wires arranged over said elastomer layer are formed at least partially to have a curved pattern.

18. A semiconductor device as set forth in Claim 1, characterized in that the wires arranged over said elastomer layer are formed at least partially to have a plurality of wires.

19. A semiconductor device as set forth in Claim 1, characterized: in that the wires arranged over said elastomer layer are oriented at a right angle with respect to the direction joining the bump electrodes connected with said wires and the center of said chip area; and in that the wires arranged at the peripheral edge portion of said chip area are longer than the wires arranged at the center portion of said chip area.

20. A process for manufacturing a semiconductor device, comprising:
(a) forming an elastomer layer over a plurality of semiconductor elements and bonding pads, which are formed in a plurality of chip areas of the principal face of a semiconductor wafer;
(b) forming through holes over said bonding pads or the electrode wires which are electrically connected with said bonding pads, by opening said elastomer layer;
(c) forming wires to be electrically connected at their one-end portions with said bonding pads through said through holes and to be arranged at their other end portions over said elastomer layer; and
(d) connecting bump electrodes with the other end portions of the wires arranged over said elastomer layer.

21. A process for manufacturing a semiconductor device, comprising:
(a) forming an elastomer layer over a plurality of semiconductor elements and bonding pads, which are formed in a plurality of chip areas of the principal face of a semiconductor wafer;
(b) forming through holes over said bonding pads or the electrode wires which are electrically connected with said bonding pads, by opening said elastomer layer;
(c) jointing an insulating tape having wires on its one face to the upper face of said elastomer layer to connect the one-end portions of said wires and said bonding pads electrically through said through holes; and
(d) connecting bump electrodes with the other end portions of the wires arranged over said elastomer layer.

22. A semiconductor device manufacturing process as set forth in Claim 20 or 21, further comprising: dicing and dividing the chip areas of said semiconductor wafer into semiconductor chips.

23. A semiconductor device manufacturing process as set forth in Claim 22, further comprising: making a test prior to dicing and dividing said chip areas into said semiconductor chips, to classify said plurality of chip areas into non-defective and defective ones.

24. A semiconductor device manufacturing process as set forth in Claim 22, further comprising: forming a fuse using at least a portion of the wires arranged over said elastomer layer, to blow the fuse of the chip areas which are determined to be defective by said testing.

25. A semiconductor device manufacturing process as set forth in Claim 20 or 21, further comprising: forming slits in the principal face or back face of said semiconductor wafer at the boundary of said chip areas, and forming protective layers in said slits.

26. A process for manufacturing a semiconductor device, comprising:
(a) forming a plurality of semiconductor elements and a plurality of bonding pads over the individual principal planes of a plurality of chip areas defined by scribe lines;
(b) forming an elastomer layer over the principal faces of said plurality of chip areas;
(c) forming through holes in said elastomer layer at positions, as corresponding to said plurality of bonding pads, individually in said plurality of chip areas;
(d) forming such conductive layers individually in said plurality of chip areas which are formed at their one-end portions over said elastomer layer and connected at their other end portions with the corresponding ones of said bonding pads through said through holes;
(e) forming bump electrodes individually in said plurality of chip areas which are connected with the one-end portions of said conductive layers; and
(f) cutting said semiconductor wafer along said scribe lines to form over its principal face a plurality of semiconductor chips having said elastomer layers, said conductive layers and said bump electrodes.

27. A semiconductor device manufacturing process as set forth in Claim 26, characterized: in that said elastomer layer is formed of a photosensitive film; and in that said through holes are formed by the photolithography technique and the etching technique.

28. A semiconductor device manufacturing process as set forth in Claim 26, characterized in that the step (d) of forming said conductive layers includes:
forming Au bump electrodes over said bonding pads; and
forming a wiring layer over said Au bump electrodes.

29. A semiconductor device manufacturing process as set forth in Claim 26, characterized in that the step (d) of forming said conductive layers includes:
forming a metal layer all over the surface of said elastomer layer including the insides of said through holes; and forming a wiring layer by patterning said metal layer.
